# FASCICULE DE BREVET EUROPEEN

(11) **EP 3 356 945 B1**
(45) Date de publication et mention de la délivrance du brevet: **04.09.2019**
(21) Numéro de dépôt: 16784233.5
(22) Date de dépôt: 27.09.2016
(51) Int. Cl.: G06F 13/12, G06F 13/40, G06F 3/06, G06F 13/16, G06F 11/10, G11C 29/52

(54) **DISPOSITIF INFORMATIQUE MUNI DE TRAITEMENT EN MEMOIRE ET DE PORTS D'ACCES ETROITS**
COMPUTERVORRICHTUNG MIT VERARBEITUNG IM SPEICHER UND SCHMALEN ZUGANGSPORTS
COMPUTER DEVICE PROVIDED WITH PROCESSING IN MEMORY AND NARROW ACCESS PORTS

(30) Priorité: 01.10.2015 FR 1559321; 11.01.2016 FR 1650186
(43) Date de publication de la demande: 08.08.2018
(73) Titulaire: Upmem, 38000 Grenoble (FR)
(72) Inventeur: DEVAUX, Fabrice, 1093 La Conversion (CH); ROY, Jean-François, 38000 Grenoble (FR)
(74) Mandataire: IP Trust
(86) Numéro de dépôt international: PCT/FR2016/052450
(87) Numéro de publication internationale: WO 2017/055732

(56) Documents cités:
- EP-A1- 0 976 054
- WO-A1-96/35176
- US-A- 5 745 791
- US-A- 5 758 108
- US-A1- 2003 222 283

## Description

### Domaine de l'invention

La présente description concerne le domaine du "traitement en mémoire", et en particulier un dispositif informatique et un procédé impliquant des circuits mémoire comportant un ou plusieurs processeurs et un bus de données de faible largeur.

### Exposé de l'art antérieur

Les ordinateurs modernes comprennent en général un circuit de traitement, souvent mis en oeuvre sous la forme d'un système sur une puce (SoC), couplé à un ou plusieurs circuits de mémoire dynamique à accès aléatoire (DRAM). De telles mémoires, qui en général nécessitent une opération de rafraîchissement périodique, sont denses est relativement rapides d'accès, et sont ainsi utilisées comme stockage principal de données en RAM dans la plupart des ordinateurs. Toutefois, au vu des quantités toujours croissantes de données à transférer entre le SoC et les circuits DRAM, de tels transferts de données tendent à ralentir le fonctionnement de l'ordinateur et conduisent à une consommation d'énergie relativement élevée.

La publication EP0976054 B1 décrit un procédé de génération d'adresses et d'arbitrage de chemin de données vers et depuis une mémoire de type SRAM, ainsi qu'un circuit permettant de convertir des données depuis un format de première taille de bits en un format de seconde taille de bits.

La publication US 5 745 791 A décrit un circuit d'interfaçage d'une mémoire d'un contrôleur réseau avec un bus de données ayant une largeur de chemin de données différente de celle de la mémoire.

Une solution qui a été proposée consiste à prévoir des circuits DRAM comportant un ou plusieurs processeurs intégrés dedans, en plus des processeurs hôtes principaux se trouvant dans le SoC. Une telle solution réduit le volume de transfert de données entre le circuit DRAM et les processeurs hôtes en permettant de déléguer certaines taches de traitement de données aux processeurs des DRAM, de sorte que ces taches de traitement peuvent être réalisées tout en évitant des transferts de données entre le circuit DRAM et les processeurs hôtes.

Une difficulté dans l'utilisation d'un processeur de données se trouvant dans une puce mémoire est que chaque puce mémoire peut ne pas voir la totalité de la largeur de bus du processeur hôte. En effet, il est de pratique courante de prévoir une série de puces mémoires dont chacune est couplée à une tranche correspondante du bus de données du processeur hôte. Les avantages d'un tel découpage en tranches du bus de données comprennent le fait que les boîtiers des puces peuvent avoir des ports de données relativement étroits, ce qui signifie moins de broches, et ainsi une consommation d'énergie réduite. En outre, les ports de données étroits permettent de construire des systèmes mémoire à grande capacité sans avoir besoin de puces d'amplificateurs tampons supplémentaires, dont l'utilisation augmenterait le coût, la consommation d'énergie, la latence et diminuerait la fréquence de fonctionnement et par conséquent la bande passante. Vu le port de données étroit de chaque puce mémoire, un processeur de la puce mémoire sera incapable de traiter des données fournies sur la largeur totale du processeur hôte.

Il existe donc un problème technique pour obtenir un système permettant un traitement en mémoire dans des puces de mémoire ayant des bus de données étroits.

### Résumé

Un objet des modes de réalisation de la présente description est de répondre au moins partiellement à un ou plusieurs problèmes de l'art

La présente invention est définie par les revendications indépendantes jointes auxquelles il convient de référer. Des caractéristiques avantageuses sont exposées dans les revendications dépendantes. Les modes de réalisation ou exemples décrits dans la présente description ci-dessous qui ne sont pas couverts par les revendications sont considérés comme ne faisant pas partie de l'invention.

Selon un aspect, on prévoit un dispositif informatique comprenant : un premier dispositif de traitement ; une pluralité de circuits mémoire, au moins un premier des circuits mémoire comprenant un ou plusieurs autres dispositifs de traitement ; un bus de données couplant le premier dispositif de traitement à chacun des circuits mémoire, dans lequel chacun des circuits mémoire a un port de données qui a une largeur de m bits et le bus de données a une largeur de n bits, n étant supérieur à m, le port de données de chaque circuit mémoire étant couplé par exemple à une tranche correspondante de m bits du bus de données, le premier dispositif de traitement étant adapté à fournir une ou plusieurs premières adresses pour une valeur de données de n bits à lire ou écrire par l'intermédiaire du bus de données, dans lequel le premier dispositif de traitement et/ou un autre circuit sont adaptés à lire ou écrire la valeur de données de n bits dans le premier circuit mémoire en convertissant la première adresse en une pluralité de deuxièmes adresses correspondant à des emplacements mémoire de m bits dans le premier circuit mémoire, au moins deux de la pluralité de deuxièmes adresses étant des adresses contiguës ; et en réalisant l'opération de lecture ou d'écriture de la valeur de données de n bits dans le premier circuit mémoire sur une pluralité d'opérations d'accès mémoire.

Selon un mode de réalisation, chaque autre dispositif de traitement comprend un ou plusieurs processeurs configurés pour effectuer des opérations de traitement des données stockées par le premier circuit mémoire sur la base de commandes fournies par le premier dispositif de traitement.

Selon un mode de réalisation, la largeur n du bus de données est un multiple p de la largeur m du port de données de chaque circuit mémoire, et il y a p circuits mémoire.

Selon un mode de réalisation, la conversion d'adresse comprend une permutation d'adresses telle qu'un ou plusieurs des bits les plus significatifs desdites une ou plusieurs premières adresses deviennent un ou plusieurs bits les moins significatifs de la pluralité de deuxièmes adresses désignant le premier circuit mémoire.

Selon un mode de réalisation, lesdites une ou plusieurs premières adresses sont des adresses dans un espace d'adressage (HGAS) du premier dispositif de traitement, et les adresses de la pluralité de deuxièmes adresses sont des adresses dans un espace d'adressage local desdits un ou plusieurs autres dispositifs de traitement, l'espace d'adressage local étant linéaire ou linéaire par segments.

Selon un mode de réalisation, le dispositif informatique comprend en outre un cache de données, et un circuit de permutation de données adapté à réaliser une permutation de ligne de cache sur une ou plusieurs lignes du cache de données, le cache de données comportant des lignes de cache mémorisant chacune une pluralité de mots de données, chaque mot de données comprenant une pluralité d'octets de données, la permutation de ligne de cache mémorisant les octets formant un premier des mots de données dans des emplacements de mémorisation du cache associés au premier circuit mémoire.

Selon un mode de réalisation, le cache de données est couplé aux circuits mémoire par l'intermédiaire d'un bus de données, et le circuit de permutation de données est un circuit de transposition d'octets couplé entre le bus de données et le cache de données et adapté à réaliser la permutation de ligne de cache de chaque valeur de données mémorisée dans ou chargée à partir du cache.

Selon un mode de réalisation, le premier dispositif de traitement et/ou un autre circuit sont adaptés à déterminer si lesdites une ou plusieurs premières adresses tombent dans un segment d'adresses associé à un ou plusieurs des autres dispositifs de traitement, et à réaliser la conversion d'adresse si lesdites une ou plusieurs premières adresses tombent dans le segment d'adresses.

Selon un mode de réalisation, une pluralité de bits les moins significatifs de la première adresse est identique à une pluralité de bits les moins significatifs de l'une des deuxièmes adresses.

Selon un mode de réalisation, un registre de commande de plus de m bits est mappé vers l'espace d'adressage du premier circuit mémoire, le registre de commande comprenant au moins un bit de commande, le premier dispositif de traitement étant adapté à réaliser une opération d'écriture dans le registre de commande sur une pluralité d'opérations d'accès mémoire, un octet du registre de commande comprenant le bit de commande étant écrit par une opération finale des opérations d'accès en mémoire et impliquant une modification du bit de commande.

Selon un mode de réalisation, le premier circuit mémoire est une puce de circuit intégré intégrant une matrice mémoire et lesdits un ou plusieurs autres dispositifs de traitement.

Selon un mode de réalisation, le premier circuit mémoire comprend une première puce de circuit intégré comprenant une matrice mémoire et une autre puce de circuit intégré comprenant lesdits un ou plusieurs autres dispositifs de traitement.

Selon un mode de réalisation, le premier circuit mémoire comprend une pluralité d'autres dispositifs de traitement, chacun étant associé à un espace d'adressage correspondant de la matrice mémoire.

Selon un mode de réalisation, le premier dispositif de traitement comprend un ou plusieurs circuits de code de correction d'erreur (ECC) adaptés à insérer un ou plusieurs bits ECC dans chaque valeur de m bits.

Selon un mode de réalisation, le premier dispositif de traitement comprend un ou plusieurs circuits de code de correction d'erreur (ECC) adaptés à générer des bits ECC à mémoriser dans le premier circuit mémoire pendant une autre opération d'accès mémoire.

Selon un autre aspect, on prévoit un procédé comprenant : réaliser, par un premier dispositif de traitement, une opération de lecture ou d'écriture d'une valeur de données de n bits dans un premier circuit mémoire d'une pluralité de circuits mémoire par l'intermédiaire d'un bus de données couplant le premier dispositif de traitement à chacun des circuits mémoire, le premier circuit mémoire comprenant un ou plusieurs autres dispositifs de traitement, dans lequel chacun des circuits mémoire comporte un port de données qui a une largeur de m bits et le bus de données a une largeur de n bits, n étant supérieur à m, le port de données de chaque circuit mémoire étant couplé par exemple à une tranche correspondante de m bits du bus de données, l'opération de lecture ou d'écriture comprenant : fournir, par le premier dispositif de traitement, une ou plusieurs premières d'adresses pour une valeur de données de n bits à lire ou écrire par l'intermédiaire du bus de données ; convertir la première adresse en une pluralité de deuxièmes adresses correspondant à des emplacements mémoire de m bits dans le premier circuit mémoire, au moins deux de la pluralité de deuxièmes adresses étant des adresses contiguës ; et réaliser l'opération de lecture ou d'écriture de la valeur de données de n bits dans le premier circuit mémoire sur une pluralité d'opérations d'accès mémoire.

Selon un mode de réalisation, le procédé comprend en outre la réalisation, par le premier dispositif de traitement, d'une permutation de ligne de cache sur une ou plusieurs lignes d'un cache de données, le cache de données comportant des lignes de cache mémorisant chacune une pluralité de mots de données, chaque mot de données comprenant une pluralité d'octets de données, la permutation de ligne de cache mémorisant lesdits octets formant un premier des mots de données dans des emplacements de mémorisation du cache associés au premier circuit mémoire.

Selon un autre aspect, on prévoit un support de stockage électronique mémorisant des instructions de programme qui amènent, lorsqu'elles sont exécutées par le premier dispositif de traitement, la mise en oeuvre du procédé susmentionné.

Selon un autre aspect, on prévoit un système informatique dans lequel un processeur hôte est connecté à plusieurs puces mémoire, ces puces mémoire intégrant un ou plusieurs processeurs de données, la connexion entre ces puces mémoire et le processeur hôte étant réalisée par un bus de données plus large que le port de données de ces puces mémoire, ces puces mémoire étant connectées au bus de données dans un mode de données parallèle pour concorder avec la largeur du bus de données.

Selon un mode de réalisation, un espace d'adressage linéaire, ou linéaire par segments, est défini, cet espace d'adressage permettant d'accéder de façon linéaire, ou linéaire par segments, à la mémoire de chaque puce mémoire.

Selon un mode de réalisation, une fonction de conversion d'adresse entre ce nouvel espace d'adressage et l'espace d'adressage d'origine du processeur hôte, permet au processeur hôte d'accéder à ce nouvel espace d'adressage.

Selon un mode de réalisation, la fonction de conversion d'adresse est mise en oeuvre directement par du matériel.

Selon un mode de réalisation, la fonction matérielle de conversion d'adresse est configurable, et cette fonction change en fonction des segments de mémoire configurables.

Selon un mode de réalisation, le nouvel espace d'adressage comprend lui-même des sous-espaces d'adressage, ces sous-espaces d'adressage étant utilisés par les processeurs de données intégrés dans les puces mémoires, leur assurant un accès linéaire, ou linéaire par segments, à leurs mémoires accessibles.

Selon un mode de réalisation, ces sous-espaces d'adressage sont mappés de façon linéaire, ou linéaire par segments, dans le nouvel espace d'adressage.

Selon un mode de réalisation, le processeur hôte comporte un cache de données, ou un cache universel servant également de cache de données, et une permutation de ligne de cache est réalisée afin de changer la fonction de conversion d'adresse, et de rendre cette dernière linéaire par segments, ce qui permet au processeur hôte d'accéder correctement à la mémoire accessible au processeur de données intégré dans les puces mémoires lorsque le processeur hôte utilise une instruction de chargement, ou de stockage, ou une quelconque instruction accédant à la mémoire, dont la largeur d'accès à la mémoire est plus grande que le port de données des puces mémoires concernées.

Selon un mode de réalisation, la permutation de ligne de cache est mise en oeuvre entièrement par du logiciel.

Selon un mode de réalisation, la permutation de ligne de cache est mise en oeuvre entièrement par du matériel.

Selon un mode de réalisation, la permutation de ligne de cache est mise en oeuvre partiellement par du logiciel et partiellement par du matériel.

Selon un mode de réalisation, le motif de données en rafale correspond de façon native à la permutation de ligne de cache, cela étant équivalent à avoir toujours une permutation de ligne de cache lorsque la ligne de cache est chargée à partir de la mémoire, ou mémorisée dans celle-ci.

Selon un mode de réalisation, plusieurs types de permutations de ligne de cache sont supportés, et des moyens de configuration permettent de spécifier des segments d'adresses et quelle sorte de permutation de ligne de cache doit être réalisée lorsqu'un accès se trouve à l'intérieur de ces segments.

Selon un mode de réalisation, les puces mémoires intègrent un ou plusieurs registres de commande plus large que le port de données de la puce mémoire, un processus de couleur de commande est utilisé, un changement de couleur de commande étant demandé pour qu'une nouvelle commande soit valide dans le registre de commande concerné.

Selon un mode de réalisation, le processeur hôte est un système sur une puce comprenant plusieurs coeurs de processeur.

Selon un mode de réalisation, le processeur hôte est un système sur une puce comprenant plusieurs bus mémoire.

Selon un autre mode de réalisation, on prévoit un système plus grand comprenant plusieurs systèmes, chacun étant tel que défini précédemment, connectés entre eux et appartenant à un même domaine de cohérence de cache, afin de construire un serveur à multiples interfaces de connexion.

Selon un mode de réalisation, chaque puce mémoire donnée est agrandie, à la fois en capacité mémoire et en largeur de port de données, afin de permettre le transfert, pendant la totalité d'une transaction en rafale, d'un code ECC couvrant la totalité des données non agrandies pendant cette transaction en rafale à partir ou à destination de cette puce mémoire donnée.

Selon un mode de réalisation, chaque puce mémoire donnée est agrandie en capacité mémoire afin de permettre de mémoriser des codes ECC, les transactions en rafale sont allongées ce qui permet le transfert d'un code ECC pendant une transaction en rafale, de sorte que le code ECC transféré protège la totalité des données non ECC transférées à partir ou à destination de cette puce mémoire donnée pendant une transaction en rafale.

Selon un mode de réalisation, le processeur de données n'est pas intégré dans les puces mémoires, mais dans un ou plusieurs circuits additionnels, placés entre le processeur hôte et les puces mémoires.

Selon un mode de réalisation, la conversion d'adresse et/ou la permutation de ligne de cache est/sont partiellement ou entièrement réalisées à l'intérieur d'un ou plusieurs circuits additionnels placés entre le processeur hôte et les puces mémoires.

Selon un aspect, on prévoit un dispositif informatique comprenant : un premier processeur ; une pluralité de dispositifs mémoire, au moins un premier des dispositifs mémoire intégrant un ou plusieurs autres processeurs ; un bus de données couplant le premier processeur à chacun des dispositifs mémoire, chacun des dispositifs mémoire comportant un port de données d'une largeur de m bits et le bus de données ayant une largeur de n bits, avec n supérieur à m, le premier processeur étant adapté à fournir une première adresse pour une valeur de données de n bits à lire ou écrire par l'intermédiaire du bus de données, le premier processeur et/ou un autre circuit étant adaptés à lire ou écrire la valeur de données de n bits dans le premier dispositif mémoire en convertissant la première adresse en une pluralité d'adresses correspondant à des emplacements mémoire de m bits dans le premier dispositif mémoire, au moins deux de la pluralité d'adresses étant des adresses contiguës ; et en réalisant l'opération de lecture ou d'écriture de la valeur de données de n bits dans le premier dispositif mémoire sur une pluralité d'opérations d'accès mémoire.

### Brève description des dessins

Les caractéristiques et avantages susmentionnés et d'autres apparaîtront clairement à la lecture de la description détaillée suivante de modes de réalisation, donnés à titre d'illustration et non de limitation en faisant référence aux dessins joints, dans lesquels :
la figure 1 illustre schématiquement un exemple de dispositif informatique ;
la figure 2 illustre schématiquement un dispositif informatique selon un exemple de réalisation de la présente description ;
la figure 3 illustre schématiquement des espaces d'adresses mémoire dans le dispositif informatique de la figure 2 selon un exemple de réalisation ;
la figure 4 illustre schématiquement un espace d'adresses mémoire de processeur hôte de la figure 3 plus en détail selon un exemple de réalisation ;
la figure 5 est un organigramme illustrant des étapes dans un procédé de réalisation d'une opération de lecture ou d'écriture selon un exemple de réalisation ;
la figure 6 représente schématiquement une distribution d'octets de données dans des circuits mémoire selon un exemple de la présente description;
la figure 7 illustre schématiquement un dispositif informatique comprenant une pluralité de banques de mémoire selon un exemple de réalisation de la présente description ;
la figure 8 illustre schématiquement un circuit mémoire plus en détail selon un exemple de réalisation ;
la figure 9 illustre schématiquement des circuits mémoire ayant une pluralité de banques virtuelles selon un exemple de réalisation ;
la figure 10A illustre schématiquement un cache de données du processeur hôte de la figure 2 selon un exemple de réalisation de la présente description ;
la figure 10B illustre schématiquement un exemple de stockage de données en ligne de cache dans des espaces d'adresses de la figure 4 selon un exemple de réalisation ;
les figures 10C à 10F illustrent schématiquement un circuit de permutation de ligne de cache pendant un fonctionnement selon un exemple de réalisation ;
la figure 11 illustre schématiquement des circuits d'un dispositif informatique selon un exemple de réalisation de la présente description ;
la figure 12 représente schématiquement un stockage horizontal et vertical de codes de correction d'erreur dans des circuits mémoire selon un exemple de réalisation ;
la figure 13 représente schématiquement un stockage horizontal et vertical de codes de correction d'erreur dans des circuits mémoire selon un autre exemple de réalisation ; et
la figure 14 illustre schématiquement un circuit mémoire plus en détail selon un autre exemple de réalisation.

### Description détaillée

Dans la description qui suit, on considérera que les termes suivants sont utilisés avec les définitions suivantes :
puce mémoire : circuit intégré comprenant une matrice mémoire, comme une matrice DRAM (mémoire dynamique à accès aléatoire) ou un autre type de matrice mémoire à accès aléatoire ;
module de traitement de données (DPU) : dispositif de traitement comprenant un ou plusieurs processeurs intégrés dans une puce mémoire ou associés d'une autre façon à une puce mémoire ;
circuit mémoire : circuit comprenant une puce mémoire, et qui peut comprendre un ou plusieurs modules de traitement de données intégrés dans la puce mémoire ou associés d'une autre façon à la puce mémoire ; et
module de traitement central hôte (HCPU) : dispositif de traitement principal d'un dispositif informatique comprenant un ou plusieurs processeurs agencés pour lire et écrire des données dans des circuits mémoire par l'intermédiaire d'un bus de données.

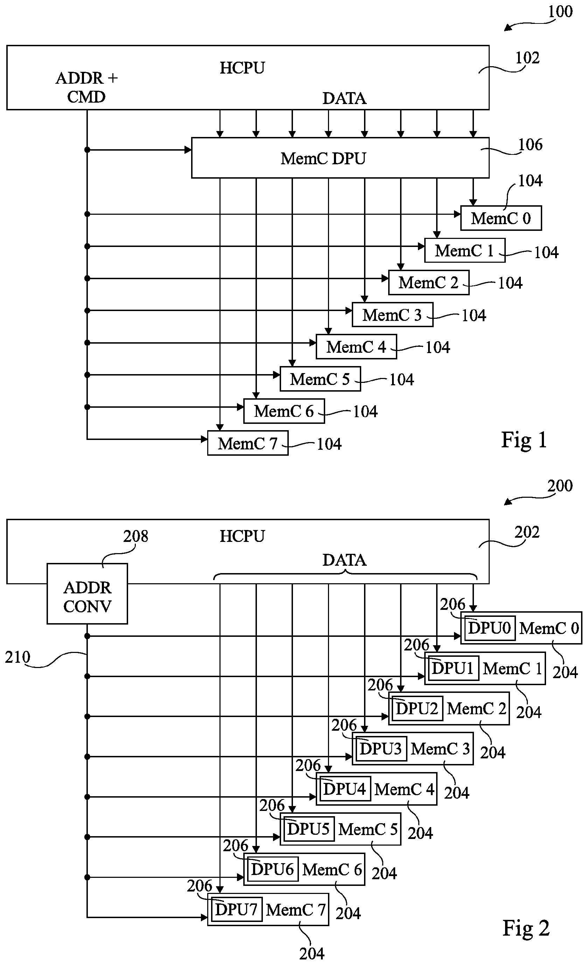

La figure 1 illustre schématiquement un dispositif informatique 100 selon un exemple de réalisation. Le dispositif informatique 100 comprend par exemple un processeur central 102, appelé ici module de traitement central hôte (HCPU). Le HCPU 102 est par exemple couplé à des circuits mémoire 104. Dans l'exemple de la figure 1, il y a 8 circuits mémoire notés MemC 0 à MemC 7.

Chacun des circuits mémoire 104 a par exemple un port de données qui est plus étroit que la largeur du bus de données du HCPU, et chaque port de données est couplé à une partie du bus de données du HCPU 102. Dans un exemple, le bus de données a une largeur de 64 bits, et chacun des circuits mémoire 104 a un port de données couplé à une tranche de 8 bits correspondante du bus de données. Comme cela a été mentionné précédemment, un avantage de prévoir des circuits mémoire ayant des ports de données qui sont plus étroits que la largeur du bus de données du HCPU 102 est que des ports de données plus étroits utilisent moins de broches, ce qui conduit à des économies en ce qui concerne la surface de la puce et la consommation d'énergie. En outre, des ports de données étroits permettent de construire des systèmes mémoire à grande capacité sans nécessiter de puces d'amplificateurs tampons supplémentaires, dont l'utilisation augmenterait le coût, la consommation d'énergie, la latence et diminuerait la fréquence de fonctionnement et par conséquent la bande passante.

Ainsi, lorsque des mots de données de 64 bits sont écrits dans les circuits mémoire, chaque circuit mémoire 104 mémorise seulement une partie du mot de données. Cela signifie que si un ou plusieurs des circuits mémoire 104 comprennent un module de traitement de données pour réaliser un traitement de données en plus du HCPU 102, un tel module de traitement de données verra seulement une portion de chaque mot de données mémorisé dans la mémoire, et par conséquent ne sera pas capable de réaliser des opérations significatives.

À titre d'exemple, on supposera qu'un dispositif de traitement doit être intégré dans chacun des circuits mémoire 104 afin de permettre de réaliser une simple fonction de comptage. En outre, on supposera que les circuits mémoire MemC 0 à MemC 7 sont mappés en commençant à l'adresse 0x04000000, où le préambule "0x" indique que la valeur est représentée en hexadécimal. Le HCPU 102 écrit un mot de 64 bits, appelé compteur, dans la mémoire principale formée par les circuits mémoire 104 à l'adresse 0x04000000. Le HCPU veut ensuite qu'un DPU du circuit de mémoire MemC 0 mette en oeuvre une fonction de comptage en incrémentant le mot de 64 bits compteur. Cependant, ce DPU verra seulement une partie [7:0] du mot de 64 bits, et sera donc incapable de remplir la fonction souhaitée. De même, le DPU de tout autre circuit de mémoire verra également seulement une partie du mot de 64 bits, et sera donc incapable de remplir la fonction souhaitée.

Comme cela est illustré sur la figure 1, un circuit de mémoire supplémentaire (MemC DPU) 106 peut comprendre un DPU et un port de données de largeur égale à celle du bus de données du HCPU 102. Ce circuit mémoire 106 peut mémoriser les mots entiers fournis sur le bus de données du HCPU, et donc le DPU de ce circuit peut effectuer des opérations sur des mots de données entiers, y compris la fonction de comptage mentionnée ci-dessus. Toutefois, compte tenu de son port de données large, ce circuit mémoire 106 utilisera un nombre élevé de broches, et n'aura donc pas les avantages associés à des ports de données étroits tels que décrits précédemment.

La figure 2 illustre schématiquement un dispositif informatique 200 selon un exemple de réalisation de la présente description.

Le dispositif informatique 200 comprend un HCPU 202 couplé à une pluralité de circuits mémoire 204. Dans l'exemple de la figure 2, il y a 8 circuits mémoire référencés MemC 0 à MemC 7. Chacun des circuits mémoire 204 comprend un DPU 206, les DPU se trouvant dans les circuits mémoire MemC 0 à MemC 7 étant respectivement référencés DPU0 à DPU7 en figure 2. Chacun des circuits mémoire 204 reçoit une tranche correspondante du bus de données du HCPU 202. Dans un exemple, le bus de données du HCPU 202 a une largeur de 64 bits, et sera représenté ici par data_bus[63:0]. Les bits de ce bus de données sont par exemple répartis en tranches parmi les circuits mémoire 204 comme suit :
- le port de données de MemC 0 est connecté à data_bus[7:0] ;
- le port de données de MemC 1 est connecté à data_bus[15:8] ;
- le port de données de MemC 2 est connecté à data_bus[23:16] ;
- le port de données de MemC 3 est connecté à data_bus[31:24] ;
- le port de données de MemC 4 est connecté à data_bus[39:32] ;
- le port de données de MemC 5 est connecté à data_bus[47:40] ;
- le port de données de MemC 6 est connecté à data_bus[55:48] ;
- le port de données de MemC 7 est connecté à data_bus[63:56] ;

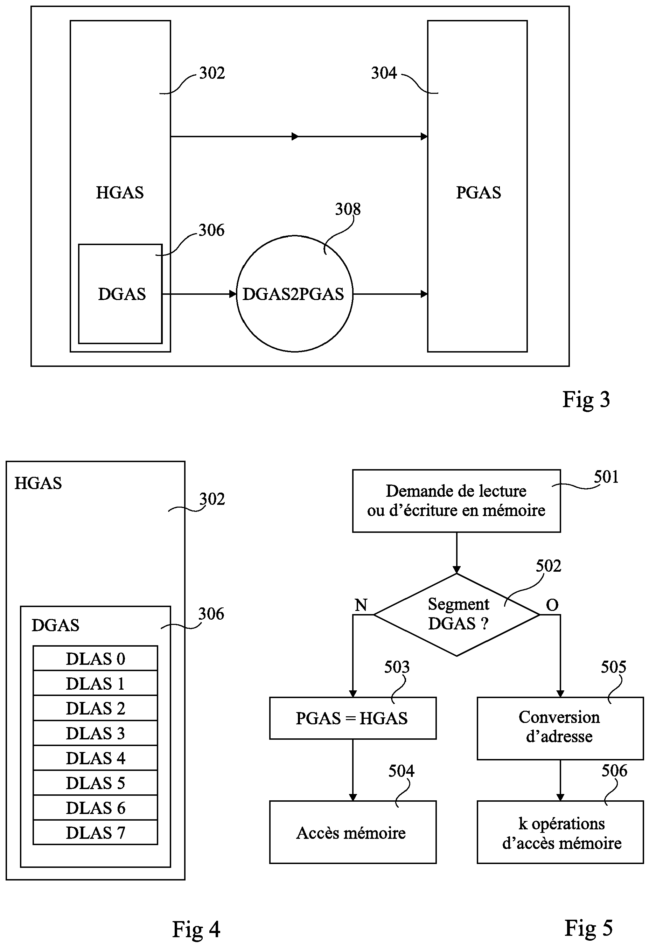

Une fonction de conversion d'adresse (ADDR CONV) 208 est par exemple mise en oeuvre par du matériel et/ou par du logiciel dans le HCPU 202, ou par un circuit séparé. Cette fonction de conversion 208 convertit des adresses de l'espace d'adressage du HCPU en adresses particulières dans l'espace d'adressage global physique (PGAS) utilisé par les circuits mémoire 204, de telle sorte qu'un mot de données qui serait autrement présent sur toute la largeur du bus de données HCPU et partiellement sur chaque circuit de mémoire 204 est à la place mémorisé entièrement par l'un des circuits mémoire. L'adresse PGAS convertie est par exemple fournie aux circuits mémoire 204, ainsi que les signaux de commande de lecture ou d'écriture appropriés, sur un bus d'adresse et de commande 210 couplé à chacun des circuits mémoire 204. La fonction de conversion d'adresse 208 va maintenant être décrite plus en détail en référence aux figures 3 à 6.

La figure 3 représente schématiquement la fonction de conversion d'adresse 208 selon un exemple de réalisation. Selon cet exemple, un espace d'adressage global HCPU (HGAS) 302 est défini, qui est l'espace d'adressage vu et utilisé par le HCPU 202. L'espace d'adressage global physique (PGAS) 304 est utilisé pour adresser le système de mémoire physique.

Selon les modes de réalisation décrits ici, le HGAS et le PGAS sont définis différemment pour au moins certaines plages dans l'espace d'adressage HGAS. Par exemple, le HGAS 302 comprend un espace de sous-adressage 306 représenté en figure 3, qui est un espace d'adressage global de DPU (DGAS).

Lorsqu'une adresse HGAS est en dehors de la région DGAS 306, l'adresse PGAS correspondante est donnée directement par la valeur de cette adresse HGAS. En d'autres termes, aucune conversion d'adresse n'est nécessaire.

Cependant, quand une adresse HGAS se trouve dans la région DGAS 306, une conversion d'adresse est réalisée afin de générer l'adresse PGAS. Par exemple, l'adresse PGAS est générée par une fonction 308 que nous appellerons ici DGAS2PGAS.

Dans certains modes de réalisation, la totalité du HGAS 302 peut correspondre au DGAS 306, ce qui signifie que des DPU des circuits mémoire peuvent accéder à l'espace d'adressage complet des circuits mémoire 204.

Le DGAS 306 comprend des plages d'adresses affectées à chaque DPU et accessibles par celui-ci, comme cela va maintenant être décrit en référence à la figure 4.

La figure 4 illustre schématiquement l'espace d'adressage global HCPU 302 plus en détail, et en particulier montre que le DGAS 306 peut comporter des zones DLAS0 à DLAS7 d'adresses mémoire correspondant aux espaces d'adressage DPU locaux (DLAS) de chacun des DPU des circuits mémoire. Le DLAS de chaque DPU est par exemple un espace d'adressage qui est linéaire, ou linéaire par segments. Cela signifie qu'un incrément de un de l'adresse accèdera à un octet de mémoire adjacent dans le même circuit mémoire pour au moins une partie des adresses du circuit mémoire. Ce n'est pas le cas quand un mot est mémorisé sur un certain nombre de circuits de mémoire différents, puisque dans un tel cas l'incrémentation de un de l'adresse provoquera l'adressage d'un circuit mémoire différent.

La figure 4 correspond à l'exemple de la figure 2 dans lequel il y a 8 circuits mémoire, avec 8 DPU correspondants, et donc il y a 8 DLAS (DLAS0 à DLAS7). Bien entendu, dans des variantes de réalisation, il pourrait y avoir un nombre différent d'espaces d'adressage locaux en fonction du nombre de DPU présents dans les circuits mémoire et en fonction du nombre de circuits mémoire.

Par exemple, dans un mode de réalisation, les espaces d'adressage locaux DLAS 0 à DLAS 7 sont mappés sur les portions de mémoire suivantes du système de mémoire, en supposant que chacun des circuits mémoire a une taille de 8 Mo (mégaoctets), et donc que la taille physique totale de la mémoire est de 64 Mo :
- DLAS 0 est mappé sur les adresses physiques 0 à 8 Mo-1, où la représentation X Mo-1 signifie un octet de moins que X mégaoctets;
- DLAS 1 est mappé sur les adresses physiques 8 à 16 Mo-1 ;
- DLAS 2 est mappé sur les adresses physiques 16 à 24 Mo-1 ;
- DLAS 3 est mappé sur les adresses physiques 24 à 32 Mo-1 ;
- DLAS 4 est mappé sur les adresses physiques 32 à 40 Mo-1 ;
- DLAS 5 est mappé sur les adresses physiques 40 à 48 Mo-1 ;
- DLAS 6 est mappé sur les adresses physiques 48 à 56 Mo-1 ;
- DLAS 7 est mappé sur les adresses physiques 56 à 64 Mo-1.

Ainsi, le circuit de mémoire MemC 0 contient les 8 premiers Mo de l'espace d'adressage physique, le circuit de mémoire MemC 1 contient les deuxièmes 8 Mo de l'espace d'adressage physique, etc. Un avantage d'une telle cartographie est que chaque DPU peut accéder à un espace d'adressage continu. Toutefois, cette mise en correspondance des espaces d'adressage DPU locaux avec les adresses physiques est simplement un exemple, et d'autres types de correspondance seraient possibles. Par exemple, les adresses physiques pourraient être des blocs de 4 Mo, dans lesquels :
- DLAS 0 est mappé sur les adresses physiques 0 à 4 Mo-1 et 32 à 36 Mo-1;
- DLAS 1 est mappé sur les adresses physiques de 4 à 8 Mo-1 et 36 à 40 Mo-1 ; etc., jusqu'à :
- DLAS 7 est mappé sur les adresses physiques 28 à 32 Mo-1 et 60 à 64 Mo-1.

La figure 5 est un organigramme illustrant des étapes dans un procédé d'accès à une mémoire selon un exemple de réalisation de la présente invention. Le procédé est par exemple mis en oeuvre par le HCPU 202 et/ou un circuit mettant en oeuvre la fonction de conversion d'adresse 208. En particulier, le procédé peut être mis en oeuvre exclusivement par le HCPU dans le cas où la fonction de conversion d'adresse 208 est mise en oeuvre dans du logiciel exécuté par un ou plusieurs processeurs du HCPU. En variante, le procédé peut être mis en oeuvre par un circuit dédié dans le cas où la fonction de conversion d'adresse 208 est mise en oeuvre par du matériel distinct du HCPU 202.

Dans une étape 501, une demande de lecture ou d'écriture mémoire est générée. Par exemple, le HCPU 202 génère cette demande de lecture ou d'écriture mémoire en exécutant une instruction de chargement ou de stockage.

Dans une étape 502, on détermine si la demande de lecture ou d'écriture mémoire implique une adresse relevant d'un segment DGAS. En d'autres termes, il est déterminé si l'adresse correspond à la zone de mémoire référencée 306 dans les figures 3 et 4, qui doit être convertie afin de générer l'adresse physique. Par exemple, la fonction de conversion d'adresse 208 mémorise une indication des plages d'adresses correspondant au DGAS 306.

Dans certains modes de réalisation, le HCPU 202 est amélioré afin de mettre en oeuvre la fonction DGAS2PGAS sans ou avec de faibles pertes de performance. Par exemple, le HCPU comprend une pluralité de registres de configuration permettant de créer le segment d'adresses DGAS spécial dans le HGAS. Par exemple, ces registres de configuration mémorisent les limites du segment DGAS ou de chaque segment DGAS dans le cas où il existe une pluralité de segments DGAS non contigus. De plus, les registres de configuration indiquent par exemple la transformation à effectuer pour la conversion d'adresses. En effet, cette conversion dépend des circuits mémoire particuliers qui sont utilisés, et en particulier de la largeur des ports de données des circuits de mémoire. Lorsque l'adresse HGAS est à l'intérieur du segment DGAS, l'adresse est en fait une adresse DGAS, et donc elle doit être convertie en une adresse PGAS.

Si l'adresse ne se trouve pas dans un segment DGAS, dans une étape 503, il est supposé que l'espace d'adressage physique global (PGAS) est égal à l'espace d'adressage DPU global (DGAS), et par conséquent dans une étape ultérieure 504, l'accès à la mémoire est traité sur la base de l'adresse HGAS.

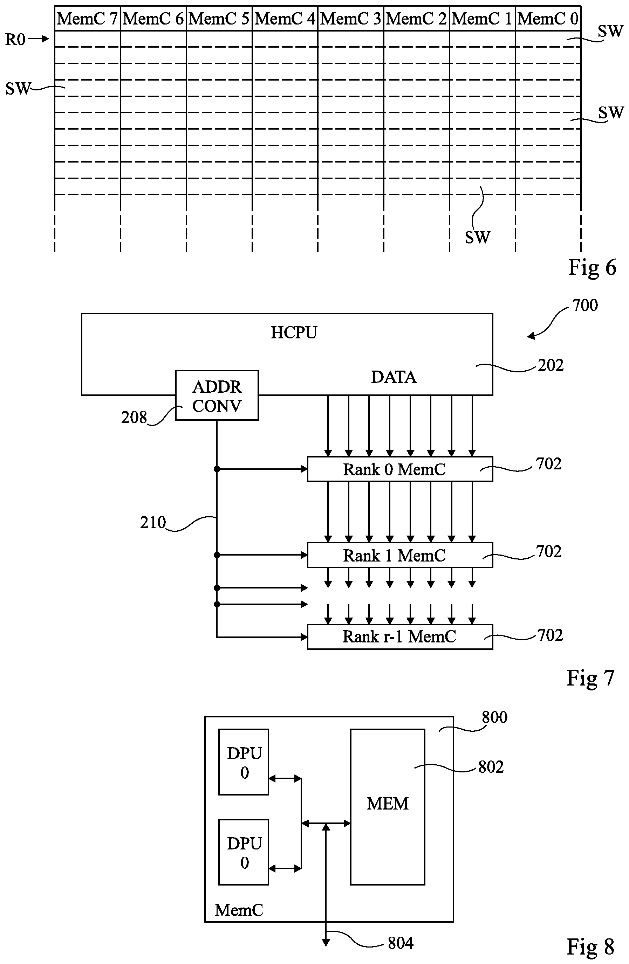

En variante, si, dans l'étape 502, il est déterminé que la demande de lecture ou d'écriture concerne une adresse tombant dans un segment DGAS, l'étape suivante est l'étape 505, dans laquelle la conversion d'adresse est effectuée en utilisant la fonction DGAS2PGAS, dont un exemple va maintenant être décrit plus en détail en référence à la figure 6.

La figure 6 illustre schématiquement un exemple de l'espace d'adressage physique du système de mémoire en supposant le cas des 8 circuits mémoire MemC 0 à MemC 7. Chaque rangée de chaque circuit mémoire MemC 0 à MemC 7 mémorise un sous-mot, qui est par exemple un octet. Chaque mot présent sur le bus de données HCPU de 64 bits est ainsi mémorisé de telle sorte qu'un sous-mot (SW) est mémorisé dans chaque rangée. Par exemple, une première rangée R0 couvrant le système de mémoire comprend une première valeur de 8 bits mémorisée dans le circuit mémoire MemC 0, une deuxième valeur de 8 bits mémorisée dans le circuit mémoire MemC 1, etc. Ainsi, pour des adresses tombant en dehors du DGAS 306 pour lesquelles aucune conversion d'adresse n'est exécutée, chaque mot dans l'espace d'adressage HCPU est mémorisé à travers chacun des circuits mémoire du système de mémoire. Dans un tel cas, l'adresse de chaque sous-mot SW ou octet est par exemple de la forme [25:0], où les 23 bits [25:3] désignent une rangée parmi les 8388608 rangées du système de mémoire, et les bits finaux [2:0] désignent l'octet dans la rangée.

Cependant, pour des adresses tombant dans le DGAS 306, la fonction de conversion suivante est par exemple appliquée entre l'adresse dans le DGAS 302 et l'adresse PGAS utilisée pour adresser les circuits mémoire :
PGAS_address[25:0] = {DGAS_address[22:0], DGAS_address [25:23]}.

Ainsi, les bits les plus significatifs [25:23] de l'adresse DGAS, qui autrement indiquerait si la rangée tombe dans le premier, deuxième, troisième, quatrième, cinquième, sixième, septième ou huitième groupe de 1048576 rangées, indiquent maintenant dans quel circuit de mémoire on doit écrire. Ainsi des adresses tombant normalement dans les 1048576 premières rangées vont maintenant être écrites dans la cellule mémoire MemC 0, les deuxièmes 1048576 rangées seront écrites dans la cellule mémoire MemC 1, etc.

Ainsi des octets formant un mot de données de 64 bits dans le DGAS 306 seront par exemple tous écrits ou lus dans huit rangées adjacentes dans l'un des circuits de mémoire. Ainsi la lecture ou l'écriture de ce mot de 64 bits est par exemple effectuée sur plus de huit opérations de lecture ou d'écriture consécutives. Dans un tel cas, les bits d'adresse DGAS [2:0] peuvent par exemple être omis, et les circuits mémoire sont par exemple capables d'effectuer des opérations sur des emplacements d'adresse successifs sans nécessiter de fournir ces bits d'adresse. Toutefois, le bit d'adresse DGAS [2] est par exemple fourni quand un mot de 32 bits doit être accédé, les bits d'adresse DGAS [1:0] sont par exemple fournis quand un accès de 16 bits doit être effectué, et les bits d'adresse DGAS [2:0] sont par exemple fournis lorsqu'un octet spécifique doit être accédé.

Cette conversion d'adresse peut, dans certains modes de réalisation, être mise en oeuvre par une permutation de bits d'adresse qui est effectuée automatiquement pour le segment DGAS. Par exemple, la nature de la permutation de bits est spécifiée par le contenu des registres de configuration correspondants. Dans certains modes de réalisation, le DGAS peut être mappé vers le HGAS comme une somme de plusieurs segments de mappage, avec une linéarité par segments. En effet, le DGAS est par exemple la somme des segments DLAS dans les circuits mémoire.

En se référant de nouveau à la figure 5, dans une étape suivante 506, k opérations d'accès à la mémoire sont effectuées sur la base des adresses physiques converties. Par exemple, dans certains modes de réalisation, l'adresse de l'opération de lecture ou d'écriture peut correspondre à un seul octet de données, auquel cas ceci peut être réalisé en une seule opération de lecture ou d'écriture et k est égal à 1. En variante, la requête de lecture ou d'écriture peut correspondre à un mot de données à lire ou à écrire, et dans un tel cas, il y aura une séquence de 8 opérations d'accès en mémoire effectuées afin d'écrire les données dans la zone DLAS correspondante dans la mémoire, et k sera égal à 8. D'autres valeurs de k sont possibles en fonction du nombre d'octets désignés par l'adresse de l'opération de lecture ou d'écriture.

La figure 7 illustre un dispositif informatique 700, qui est similaire au dispositif 200 de la figure 2, mais au lieu de comporter une seul banque de circuits mémoire 204, il comporte une pluralité de banques 702 de circuits mémoire. Par exemple le HCPU 202 communique avec un total de r banques de circuits mémoire, ces banques étant notées Rank 0 MemC à Rank r-1 MemC. Chaque banque comprend par exemple une pluralité de circuits mémoire. Le bus de données du HCPU est couplé à chacune des banques de mémoire, et la fonction de conversion d'adresse 208 est par exemple appliquée indépendamment pour chaque banque. Par exemple, dans le cas où il y a deux banques 0 et 1, la banque 0 comprend par exemple les zones DLAS 0 à 7, tandis que la banque 1 comprend par exemple les zones DLAS 8 à 15.

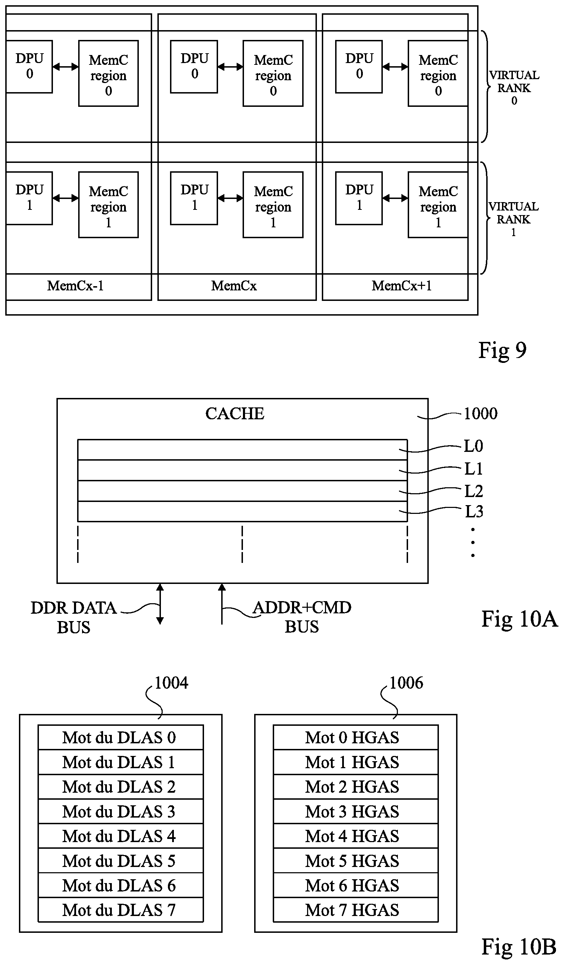

Alors que dans le mode de réalisation de la figure 2, chacun des circuits mémoire 204 comporte un seul DPU 206, dans des variantes de réalisation, chaque circuit mémoire 204 peut comporter une pluralité de DPU, comme cela va être décrit en faisant référence aux figures 8 et 9.

La figure 8 illustre schématiquement un circuit mémoire 800 comme une alternative à chacun des circuits mémoire 204 de la figure 2. Par exemple, le circuit mémoire 800 est une puce de mémoire intégrant une matrice mémoire (MEM) 802 et deux DPU référencés DPU 0 et DPU 1. Les DPU DPU 0 et DPU 1 et la matrice mémoire 802 sont chacun couplés par exemple à une tranche 804 du bus HCPU. Dans ce mode de réalisation, chacun des DPU DPU 0 et DPU 1 par exemple partage le même l'espace d'adressage local DPU et est par exemple capable d'accéder à la totalité de l'espace d'adressage de la matrice mémoire 802. De même, le DPU de chaque autre circuit mémoire, partage par exemple également le même DLAS.

La figure 9 représente un mode de réalisation alternatif dans lequel la mémoire de chaque circuit mémoire est divisée en une pluralité de régions. Dans l'exemple de la figure 9 trois circuits mémoire MemC x-1, MemC x et MemC x+1 comprennent chacun deux régions, une région notée MemC region 0, et l'autre notée MemC region 1. Un DPU est associé à chaque région de mémoire, et peut seulement accéder à cette région. Par exemple, le DPU 0 de chaque circuit mémoire peut seulement accéder à la région notée MemC region 0, et le DPU 1 de chaque circuit mémoire peut seulement accéder à la région notée MemC region 1. Ainsi, les régions 0 du circuit de mémoire considéré peuvent être considérées comme une banque virtuelle, et les régions 1 comme une autre banque virtuelle, et les régions 0 et 1 sont notées comme telles dans la figure 9 comme VIRTUAL RANK 0 et VIRTUAL RANK 1 respectivement. Ainsi, au lieu de considérer que chaque circuit mémoire comprend une pluralité de DPU, il est possible de considérer simplement qu'il existe une pluralité de banques, et d'adopter la solution décrite ci-dessus en relation avec la figure 7.

Dans des modes de réalisation alternatifs, chaque DPU peut être capable d'accéder à une pluralité de régions, mais la totalité de l'espace d'adressage de la mémoire physique des circuits de mémoire n'est pas accessible par les DPU. Dans un tel cas, un DLAS est par exemple défini pour chaque région de mémoire accessible, de sorte que le DPU ou les DPU associés y ont accès.

En mettant en oeuvre la fonction de conversion d'adresse comme une permutation de bits d'adresse comme décrit ci-dessus, la conversion d'adresse peut être effectuée de façon plus ou moins transparente d'un point de vue des performances. Cependant, le HCPU accède encore à l'espace d'adressage DGAS par des opérations de lecture et d'écriture de la taille d'un octet. Une conversion plus efficace peut être effectuée en utilisant des accès mémoire en rafales comme cela va maintenant être décrit plus en détail en se référant aux figures 10A et 10B.

La figure 10A illustre schématiquement un cache de données 1000 (CACHE) selon un exemple de réalisation. Un cache de données permet à un dispositif de traitement de stocker localement des données et d'y accéder rapidement. Le cache de données 1000 est par exemple intégré dans le HCPU 202, et est par exemple couplé à un bus de données (DDR DATA BUS) et à un bus d'adresse et de commande (ADDR+CMD BUS) du HCPU 202. Le cache de données 1000 comprend par exemple des lignes de cache L1, L2, L3, etc, le nombre de lignes étant fonction de la taille du cache. Chaque ligne de cache a par exemple la taille d'une transaction mémoire en rafale. Une transaction mémoire en rafale est par exemple une opération d'accès mémoire qui améliore les performances en permettant un accès rapide en lecture ou en écriture à un bloc d'adresses mémoire.

Par exemple, une transaction d'écriture en rafale implique une succession d'accès en écriture, un premier accès en écriture utilisant une adresse générée par le HCPU, et les accès en écriture suivants utilisant des adresses incrémentées automatiquement, par exemple, par les circuits mémoire, à partir de celle utilisée par le premier accès en écriture, la taille de l'incrément correspondant à la largeur du bus HCPU en octets.

De même, une transaction de lecture en rafale implique une succession d'accès en lecture, un premier accès en lecture utilisant une adresse générée par le HCPU et les accès en lecture suivants utilisant des adresses incrémentées automatiquement à partir de celle utilisée par le premier accès en lecture, la taille de l'incrément correspondant à la largeur du bus HCPU en octets.

Par exemple, selon les protocoles DDR3 (double débit de données type 3) et DDR4 (DDR type 4), une transaction en rafale se compose de huit accès successifs, chaque accès déplaçant 8 octets de données. Par conséquent, la quantité de données déplacée par l'opération en rafale est de 64 octets. Par ailleurs, l'adresse du premier accès est par exemple alignée sur une limite de 64 octets.

Dans certains modes de réalisation, l'accès à la mémoire en rafale est basé sur une rafale carrée, c'est-à-dire une rafale pour laquelle la largeur en octets est égale à sa profondeur en nombre d'accès.

Dans un exemple, le cache de données 1000 fonctionne sur la base du protocole DDR3 ou DDR4, et donc chaque ligne de cache L1, L2, etc., est par exemple de 64 octets. Les protocoles DDR3 et DDR4 utilisent des rafales carrées. En effet, dans le contexte de DDR3/DDR4, le HCPU 202 communique avec sa mémoire au moyen d'opérations en rafale comprenant chacune 8 accès en rafale de 64 bits (8 octets), ces accès étant appelés ici "accès en rafale 0" à "accès en rafale 7".

Une transaction de lecture ou écriture en rafale, comprenant 64 octets désignés ici comme B00 à B63, est par exemple organisée comme suit :
accès en rafale 0 : B00 B01 B02 B03 B04 B05 B06 B07
accès en rafale 1 : B08 B09 B10 B11 B12 B13 B14 B15
accès en rafale 2 : B16 B17 B18 B19 B20 B21 B22 B23
accès en rafale 3 : B24 B25 B26 B27 B28 B29 B30 B31
accès en rafale 4 : B32 B33 B34 B35 B36 B37 B38 B39
accès en rafale 5 : B40 B41 B42 B43 B44 B45 B46 B47
accès en rafale 6 : B48 B49 B50 B51 B52 B53 B54 B55
accès en rafale 7 : B56 B57 B58 B59 B60 B61 B62 B63

Ainsi, lorsqu'elle est remplie avec une transaction en rafale, l'une des lignes de cache de 64 octets de la mémoire cache de données 1000 peut par exemple être représentée comme un tableau 8x8, contenant :

| | | | | | | | |
|---|---|---|---|---|---|---|---|
| B00 | B01 | B02 | B03 | B04 | B05 | B06 | B07 |
| B08 | B09 | B10 | B11 | B12 | B13 | B14 | B15 |
| B16 | B17 | B18 | B19 | B20 | B21 | B22 | B23 |
| B24 | B25 | B26 | B27 | B28 | B29 | B30 | B31 |
| B32 | B33 | B34 | B35 | B36 | B37 | B38 | B39 |
| B40 | B41 | B42 | B43 | B44 | B45 | B46 | B47 |
| B48 | B49 | B50 | B51 | B52 | B53 | B54 | B55 |
| B56 | B57 | B58 | B59 | B60 | B61 | B62 | B63 |

A l'intérieur d'une telle ligne de cache, le HCPU 202 est par exemple en mesure d'accéder à : tout octet ; tout mot de 16 bits, composé de deux octets {Bn, Bn+1}, où n est divisible par 2 ; un mot de 32 bits, composé des octets {Bn, Bn+1, Bn+2, Bn+3}, où n est divisible par 4 ; et un mot de 64 bits, composé des 8 octets d'une ligne du tableau.

Dans certains modes de réalisation, les octets se trouvant dans une ligne de cache de la mémoire cache de données 1000 sont soumis à une permutation afin de modifier la façon dont ils sont stockés dans les circuits mémoire. Par exemple, au lieu de remplir une ligne de cache avec les données à mesure qu'elles arrivent du bus de données DDR du HCPU 202, la permutation suivante est effectuée : en représentant la ligne de mémoire cache sous forme d'un tableau 8x8, chaque octet situé aux coordonnées (x,y) est échangé avec l'octet situé aux coordonnées (y,x). Une fois permutée, la ligne de cache est donc remplie comme suit :

| | | | | | | | |
|---|---|---|---|---|---|---|---|
| B00 | B08 | B16 | B24 | B32 | B40 | B48 | B56 |
| B01 | B09 | B17 | B25 | B33 | B41 | B49 | B57 |
| B02 | B10 | B18 | B26 | B34 | B42 | B50 | B58 |
| B03 | B11 | B19 | B27 | B35 | B43 | B51 | B59 |
| B04 | B12 | B20 | B28 | B36 | B44 | B52 | B60 |
| B05 | B13 | B21 | B29 | B37 | B45 | B53 | B61 |
| B06 | B14 | B22 | B30 | B38 | B46 | B54 | B62 |
| B07 | B15 | B23 | B31 | B39 | B47 | B55 | B63 |

Le cache est toujours accédé en utilisant une adresse de l'espace d'adressage global physique, et ainsi la fonction de conversion d'adresse DGAS2PGAS est modifiée pour tenir compte de la permutation d'octets. Comme cela a été décrit ci-dessus, la fonction de conversion d'adresse initiale était la suivante :
PGAS_address[25:0] = {DGAS_address[22:0], DGAS_address [25:23]}.

En permutant l'octet dans la ligne de mémoire cache, les bits d'adresse PGAS[2:0], qui correspondent à des emplacements d'adresse dans la direction x de la matrice 8x8, sont échangés avec les bits d'adresse PGAS[5:3], correspondant à la direction y dans la matrice 8x8. Ainsi, la nouvelle conversion d'adresse devient :
PGAS_address[25:0] = {DGAS_address [22:3], DGAS_address [25:23], DGAS_address [2:0]}.

On notera que les bits d'adresse PGAS [2:0] sont maintenant égaux aux bits d'adresse DGAS [2:0]. De manière avantageuse, cela signifie que des opérations d'accès à la mémoire adressant des valeurs de 16 bits, 32 bits et 64 bits deviennent possibles. En particulier, lors de la lecture ou de l'écriture de la ligne de cache, il devient possible d'effectuer l'une quelconque des opérations d'accès suivantes :
- un mot de 16 bits, 16 bits alignés, formé de 2 octets avec des adresses DGAS consécutives ;
- un mot de 32 bits, 32 bits alignés, formé de 4 octets avec des adresses DGAS consécutives ; ou
- un mot de 64 bits, 64 bits alignés, formé de 8 octets avec des adresses DAS consécutives.

Bien que la description ci-dessus mentionne des accès mémoire d'une certaine taille, alignés avec la même taille, en utilisant deux lignes de cache à la fois, des accès DGAS non alignés de 16 bits, 32 bits et 64 bits peuvent également être pris en charge. En particulier, cela peut par exemple être obtenu en fractionnant un accès qui coupe des lignes de cache adjacentes en deux accès successifs comportant chacun une ligne de cache unique, ou en effectuant des accès simultanés aux deux lignes de cache et en multiplexant ensuite les données de lecture pour extraire les parties pertinentes.

L'exemple ci-dessus suppose que la permutation (x, y)-> (y, x) est appliquée à une rafale de ligne de cache carrée. D'autres permutations sont aussi possibles. Par exemple, la permutation (x, y)-> (y, ∼ x) pourrait être utilisée à la place, le symbole "∼" signifiant le complément à 1, autrement dit, 7-x. La conséquence est que les indices des puces de mémoire sont inversés.

L'exemple ci-dessus suppose que la rafale de mémoire est carrée, ce qui est le cas pour les protocoles DDR3 et DDR4. Cependant, d'autres protocoles impliquent une rafale rectangulaire. Par exemple, le protocole DDR2 comprend 4 accès, chaque accès déplaçant 8 octets. Une opération de permutation similaire à celle décrite ci-dessus peut être appliquée à une telle rafale, comme cela va maintenant être décrit plus en détail.

Dans le contexte DDR2, la ligne de mémoire cache a une taille de 32 octets, et quand elle est remplie par une opération en rafale et représentée sous forme d'un tableau 8x4, elle contient:

| | | | | | | | |
|---|---|---|---|---|---|---|---|
| B00 | B01 | B02 | B03 | B04 | B05 | B06 | B07 |
| B08 | B09 | B10 | B11 | B12 | B13 | B14 | B15 |
| B16 | B17 | B18 | B19 | B20 | B21 | B22 | B23 |
| B24 | B25 | B26 | B27 | B28 | B29 | B30 | B31 |

En appliquant la transformation (x, y) -> (y, x), et en représentant la ligne de mémoire cache de 32 octets sous forme d'un tableau de 4 x 8, on obtient:

| | | | |
|---|---|---|---|
| B00 | B08 | B16 | B24 |
| B01 | B09 | B17 | B25 |
| B02 | B10 | B18 | B26 |
| B03 | B11 | B19 | B27 |
| B04 | B12 | B20 | B28 |
| B05 | B13 | B21 | B29 |
| B06 | B14 | B22 | B30 |
| B07 | B15 | B23 | B31 |

Encore une fois, la fonction de conversion d'adresse DGAS2PGAS est par exemple modifiée pour tenir compte de cette permutation d'octets. Comme cela est décrit ci-dessus, la fonction de conversion d'adresse initiale était la suivante :
PGAS_address[25:0] = {DGAS_address[22:0], DGAS_address [25:23]}.

On notera que cette permutation d'adresses initiale est la même que pour l'exemple DDR3/DDR4, étant donné que cette permutation initiale dépend uniquement du nombre de circuits de mémoire en parallèle, qui est par exemple de huit pour les exemples DDR2 et DDR3/DDR4.

La nouvelle permutation pour l'exemple DDR2 est par exemple :
PGAS_address[25:0] = {DGAS_address [22:2], DGAS_address [25:23], DGAS_address[1:0]}.

Le HCPU peut par exemple effectuer les accès suivants en lecture ou en écriture:
- un accès 16 bits, 16 bits alignés, dans le DGAS ; ou
- un accès 32 bits, 32 bits alignés, dans le DGAS.

L'accès à 64 bits dans le DGAS ne fonctionne pas parce que la linéarité DGAS a seulement une taille de 4 octets, ce qui signifie que seuls les deux bits les moins significatifs de l'adresse DGAS sont égaux aux deux bits les moins significatifs de l'adresse PGAS.

Alors que dans l'exemple DDR2 la largeur de la rafale rectangulaire est plus grande que sa profondeur, les transformations décrites ici peuvent être appliquées de manière égale à d'autres configurations de rafale, par exemple, lorsque la largeur est inférieure à la profondeur.

La permutation décrite ci-dessus de la ligne de mémoire cache peut par exemple être réalisée par du logiciel ou du matériel.

Dans le cas d'une permutation par logiciel, la permutation peut par exemple être réalisée sur 36 cycles. Ce nombre de cycles peut être comparé au coût d'un accès DRAM aléatoire (page fermée), qui est généralement de plus de 200 cycles. Ainsi, le coût d'une permutation par logiciel est relativement faible.

En variante, dans une permutation de ligne de cache par du matériel, le HCPU 202 comprend par exemple un ou plusieurs circuits de permutation. Ces circuits sont par exemple mis en oeuvre dans le HCPU 202, ou comme partie d'un circuit séparé couplé entre le HCPU et les circuits mémoire. L'opération de permutation n'est pas par exemple réalisée en pipeline, puisque l'ensemble du réseau de 8x8 doit être chargé avant que la permutation commence.

Le circuit de permutation pourrait être mis en oeuvre en utilisant :
- des registres à double port, avec un bus d'écriture et un bus de lecture orthogonaux ; ou
- une mémoire à un seul port, dont les entrées sont des registres à décalage orthogonaux au bus mémoire ;
- une matrice 2D de registres à décalage, avec le décalage possible dans un sens, puis dans l'autre sens.

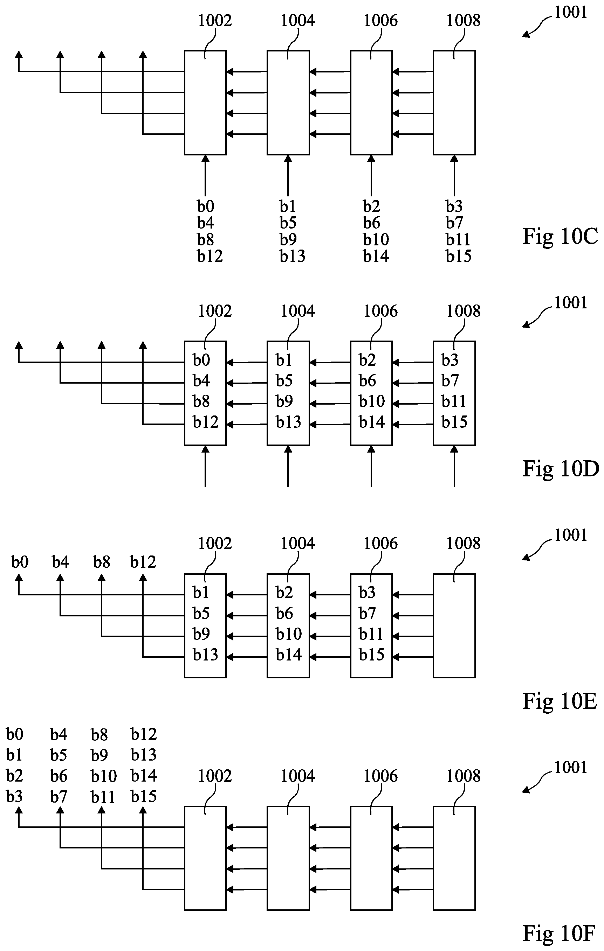

Un exemple de mise en oeuvre d'un circuit de permutation va maintenant être décrit en référence aux figures 10C à 10E sur la base d'un exemple dans lequel la ligne de cache comprend 16 octets b0 à b15. Il sera évident pour l'homme du métier de savoir comment cette mise en oeuvre pourrait être adaptée à d'autres tailles de ligne de cache, tels que les exemples à 32 et 64 octets décrits ci-dessus.

Les figures 10C à 10F illustrent un circuit de permutation 1001 pour réaliser des permutations de ligne de cache pendant une opération de lecture d'une ligne de cache dans le cache de données. Bien sûr, les opérations inverses pourraient être réalisées lors de l'écriture d'une ligne de cache dans le cache.

Le circuit de permutation 1001 comprend par exemple des registres 1002, 1004, 1006 et 1008, qui sont par exemple des registres à décalage. Comme cela est représenté en figure 10C, le registre 1002 a une ligne d'entrée couplée de façon à recevoir les octets b0, b4, b8 et b12 d'une ligne de cache, le registre 1004 a une ligne d'entrée couplée de façon à recevoir les octets b1, b5, b9 et b13 d'une ligne de cache, le registre 1006 a une ligne d'entrée couplée de façon à recevoir les octets b2, b6, b10 et b14 d'une ligne de cache, et le registre 1008 a une ligne d'entrée couplée de façon à recevoir les octets b3, b7, b11 et b15 d'une ligne de cache.

La figure 10D illustre le circuit de permutation 1001 après que les octets b0 à b15 ont été chargés dans les registres 1002 à 1008, par exemple par des opérations de décalage.

La figure 10E illustre une première opération de sortie pendant laquelle les octets b0, b4, b8 et b12 chargés dans le registre 1002 sont fournis en parallèle pour former une première rangée de la ligne de cache permutée. En même temps, les octets provenant du registre 1004 sont décalés vers le registre 1002, les octets provenant du registre 1006 sont décalés vers le registre 1004 et les octets provenant du registre 1008 sont décalés vers le registre 1006.

Les opérations de sortie et de décalage représentées en figure 10E sont ensuite répétées jusqu'à ce que, comme cela est représenté en figure 10F, tous les octets aient été fournis par les registres 1002 à 1008 pour former la ligne de cache permutée.

Le chargement initial des données dans les registres 1002 à 1008 peut être réalisé par des opérations de décalage en utilisant les registres à décalage tels que mentionnés précédemment, ou par des opérations d'écriture en mémoire dans les registres. En outre, bien que dans l'exemple décrit en relation avec les figures 10E et 10F les valeurs de données soient fournies à partir des registres 1002, 1004, 1006, 1008 en réalisant des opérations de décalage, dans des variantes de réalisation les données pourraient être fournies par des opérations de lecture mémoire.

Dans certains modes de réalisation, la permutation de ligne de cache peut être réalisée pour tous les accès mémoire, sans tenir compte du fait qu'elle concerne ou pas un circuit mémoire ayant un DPU intégré. En effet, le sens dans lequel une ligne de cache est écrite dans le système de mémoire est en général sans conséquence, et par conséquent réaliser la permutation sur toutes les données serait possible. Dans un tel cas, la permutation d'octets de ligne de cache pourrait être réalisée par une modification de la manière dont les lignes de cache sont chargées à partir du bus DDR2, DDR3 ou DDR4, ou écrites dans celui-ci. Une conversion d'adresse est encore par exemple réalisée pour des adresses DGAS.

En effet, en référence à la figure 10B, lors de la lecture dans le DGAS 1004, une ligne de cache de 64 octets contient des mots de 8 x 64 bits, chacun de ces mots appartenant à un DLAS différent. Ainsi ces 8 mots ne sont pas mappés de façon contiguë dans le DGAS, et sont par exemple séparés de 8 Mo dans le cas où le système mémoire a une taille de 64 Mo assurée par 8 circuits mémoire. Lors de la lecture dans le HGA 1006, une ligne de cache de 64 Mo contient 8 mots de 64 bits, et les 8 mots sont mappés de façon contiguë dans le HGAS.

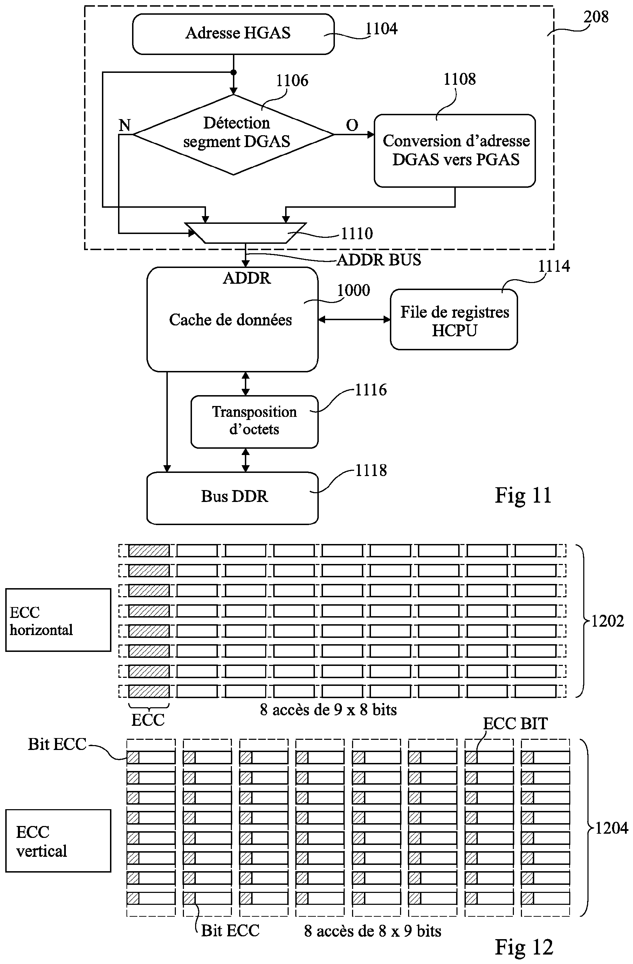

L'organigramme de la transformation va maintenant être décrit plus en détail en faisant référence à la figure 11.

La figure 11 illustre une partie du dispositif informatique 200 comprenant le cache 1000 de la figure 10A et la fonction de conversion d'adresse 208 de la figure 2. Les circuits de la figure 11 sont par exemple tous intégrés dans le HCPU 202.

La fonction de conversion d'adresse 208 est par exemple mise en oeuvre par du matériel ou du logiciel. Cette fonction est représentée en figure 11 par un organigramme constitué de plusieurs opérations. La conversion est basée sur une adresse HGAS, qui doit être la cible de l'opération d'accès au cache de données. Dans une opération 1106, on détermine si l'adresse HGAS correspond à un segment DGAS. Si oui, dans une opération suivante 1108, la conversion d'adresse DGAS vers PGAS est réalisée, par exemple sur la base de l'une des fonctions DGAS2PGAS décrites précédemment, en fonction du type de l'opération de rafale mémoire. Un multiplexeur 1110 sélectionne par exemple l'adresse convertie dans le cas où l'adresse HGAS correspond à un segment DGAS, ou autrement sélectionne l'adresse HGAS, pour former l'adresse PGAS pour adresser le cache 1000. L'adresse est fournie sur un bus d'adresse (ADDR BUS) à un port d'adresses (ADDR) du cache de données 1000.

Le cache de données 1000 est couplé à une file de registres HCPU 1114 du HCPU 202. La file de registres HCPU 1114 est par exemple la file de registres d'usage général accessible par des instructions exécutées par le HCPU 202. Le cache de données est rempli avec des données par l'intermédiaire d'un circuit de transposition d'octets (BYTE TRANSPOSITION) 1116, qui est par exemple mis en oeuvre par un circuit similaire au circuit de permutation 1001 des figures 10C à 10F. Le circuit de transposition d'octets 1116 est par exemple couplé entre le bus de données DDR (DDR BUS) 1118 et le cache de données 1000. Toutefois, dans d'autres modes de réalisation, il pourrait être disposé ailleurs, comme dans le chemin entre le cache de données 1000 et la file de registres HCPU 1114.

Dans certains modes de réalisation, plutôt que d'utiliser un circuit de permutation de ligne de cache comme le circuit de transposition d'octets 1116 pour réaliser des permutations de ligne de cache, comme cela a été mentionné précédemment, cela pourrait être à la place réalisé par du logiciel, en lisant et en écrivant des octets entre les circuits mémoire et le cache de données. Ainsi, des écritures de 16 bits, 32 bits, et 64 bits sont en fait converties en des séquences d'écriture sur 8 bits, ce qui rompt la granularité de ces opérations d'écriture. Un accès standard de 16 bits, 32 bits ou 64 bits qui est aligné avec sa propre taille va avoir une certaine granularité, mais lorsque seulement certains des bits sont écrits dans une opération d'écriture donnée, la granularité est rompue. En effet, à la suite de chaque opération d'écriture, tous les octets concernés par l'opération d'écriture doivent être écrits, puisque sinon la granularité du système serait compromise. La granularité est rompue si, à la suite d'une opération d'écriture donnée, un mot de données contient certains octets qui ont déjà été écrits, et d'autres octets qui sont en attente d'écriture. Par exemple, un registre de commande ayant une largeur plus grande que la largeur du port de données d'un circuit mémoire peut être mappé dans le DGAS. Si ce registre de commande est écrit seulement de façon partielle, la commande devient sans signification. Ce problème est par exemple résolu en incluant au moins un bit de commande dans le registre de commande, indiquant quand la commande est valide. Le bit de commande est inclus dans un octet final du registre de commande à écrire, et est par exemple inversé pendant chaque opération d'écriture. De cette manière, le DPU va prendre en compte une commande lue dans le registre de commande seulement une fois que le bit de commande a changé de couleur, en d'autres termes une fois qu'il a été inversé, par rapport à la commande précédente.

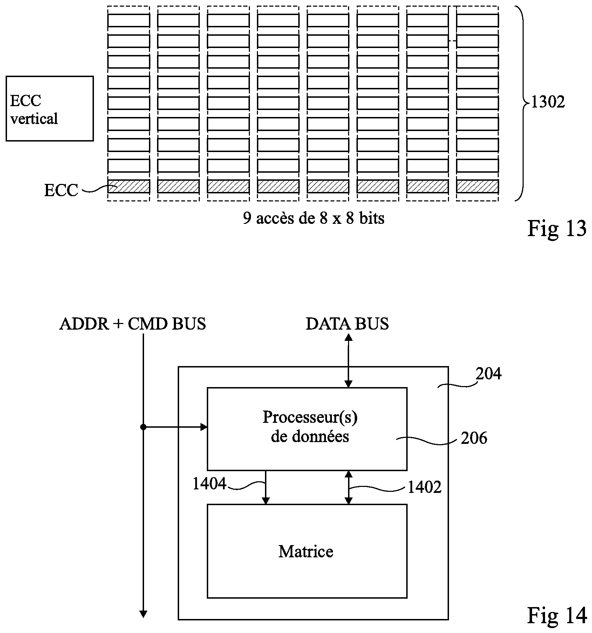

Dans certains modes de réalisation, les données mémorisées dans les circuits mémoire 204 peuvent inclure un code de correction d'erreur (ECC), comme on va le décrire maintenant en faisant référence aux figures 12 et 13.

La figure 12 représente schématiquement un stockage horizontal et un stockage vertical de codes de correction d'erreur dans les circuits mémoire 204 selon un exemple de réalisation.

Un bloc 1202 en figure 12 représente le stockage horizontal. Chaque octet de données est représenté par un rectangle vide, les données étant mémorisées sur huit circuits mémoire représentés par les huit colonnes de rectangles. Un neuvième circuit mémoire est par exemple ajouté pour mémoriser, pour chaque rangée horizontale de données, les bits ECC associés. Cependant, comme chaque DPU interne d'un circuit mémoire peut modifier les données mémorisées par ce circuit mémoire, chaque circuit mémoire devrait être capable d'accéder et de modifier les données ECC lorsque les données changent. Cela n'est pas possible dans l'agencement à stockage horizontal. En outre, puisque chaque valeur ECC est associée à une rangée d'octets horizontale, chaque circuit mémoire devrait aussi avoir accès aux données mémorisées par d'autres circuits mémoire afin de vérifier et de recalculer une valeur ECC.

Un bloc 1204 en figure 12 représente le stockage vertical. Comme cela est représenté par une portion hachurée associée à chaque octet de données, les bits ECC associés à une colonne verticale d'octets d'une colonne sont répartis entre ces octets. Par exemple, une ou plusieurs cellules de mémorisation additionnelles sont prévues pour chaque octet afin de mémoriser un ou plusieurs bits additionnels d'ECC. Le port de données du circuit mémoire est de même agrandi du même nombre de bits. Le DPU d'un circuit mémoire est ainsi capable de reconstruire l'ECC en combinant le bit ou les bits ECC mémorisés avec chaque octet dans un certain nombre de sous-mots dans la même colonne. Par exemple il y a i bits d'ECC associés à chaque octet, et l'ECC comprend ixj bits, en d'autres termes les bits ECC associés à j bits d'une colonne, où i est par exemple égal à un ou plus, et j est par exemple égal à au moins deux. Dans ce mode de réalisation, le HCPU 202 comprend par exemple un seul circuit ECC pour générer les bits ECC à partir d'un groupe de huit octets, puis ces bits sont répartis entre les octets. Par exemple, le HCPU comprend un circuit ECC associé à chaque circuit mémoire de sorte que des valeurs ECC peuvent être calculées en parallèle. Chaque circuit mémoire qui intègre un DPU comprend aussi par exemple un circuit ECC pour vérifier les bits ECC, et générer de nouveaux bits ECC à chaque fois qu'une valeur de données est modifiée.

La figure 13 représente schématiquement un bloc 1302 représentant un mode de stockage vertical alternatif de bits ECC. Dans l'exemple de la figure 13, les bits ECC associés à j rangées d'octets d'une colonne donnée sont stockés dans une rangée additionnelle dédiée au stockage des données ECC. Les bits ECC peuvent ainsi être accédés en réalisant une opération de lecture ou d'écriture additionnelle. Par exemple, la longueur de la rafale est étendue de 8 à 9 accès. Dans ce mode de réalisation, le HCPU 202 comprend par exemple un certain nombre de circuits ECC égal au nombre d'octets dans chaque accès. Ainsi, dans l'exemple de la figure 13 dans lequel chaque accès comprend huit octets, le HCPU 202 comprend par exemple huit circuits ECC fonctionnant en parallèle. Chaque circuit mémoire qui intègre un DPU comprend aussi par exemple un circuit ECC pour vérifier les bits ECC, et générer de nouveaux bits ECC à chaque fois qu'une valeur de données est modifiée.

La figure 14 illustre schématiquement l'un des circuits mémoire 204 de la figure 2 plus en détail selon un exemple de réalisation dans lequel le DPU 206 n'est pas intégré directement dans la puce de circuit intégré contenant la matrice mémoire (ARRAY), mais dans une puce de circuit intégré séparée couplée à la matrice mémoire par un bus de données 1402 et un bus d'adresse 1404. Le DPU 206 comprend par exemple un ou plusieurs processeurs de données (DATA PROCESSOR(S)) couplés au bus d'adresse et de commande (ADDR+CMD BUS) et à une tranche du bus de données (DATA BUS) du HCPU 202.

Un avantage des modes de réalisation décrits ici est que, en prévoyant une conversion d'adresse, des mots de données peuvent être stockés verticalement dans un seul circuit mémoire ayant un port de données d'une largeur inférieure au mot de données. Ainsi, un dispositif de traitement de données du circuit mémoire est capable d'accéder aux mots de données, et de réaliser des opérations sur les mots de données.

Avec la description ainsi faite d'au moins un mode de réalisation illustratif, diverses altérations, modifications et améliorations apparaîtront facilement à l'homme de l'art. Par exemple, il sera clair pour l'homme de l'art que bien qu'on ait décrit des modes de réalisation spécifiques sur la base d'un bus de données HCPU qui a une largeur de 64 bits, et une ou plusieurs banques de huit circuits mémoire ayant des ports de données de 8 bits, de nombreux agencement différents seraient possibles.

En outre, bien que dans les exemples de réalisation décrits ici chaque circuit mémoire corresponde à un circuit intégré comportant un ou plusieurs DPU intégrés, dans des variantes de réalisation lesdits un ou plusieurs DPU pourraient être formés dans un ou plusieurs autres circuits intégrés séparés du circuit mémoire.

## Revendications

1. Dispositif informatique comprenant :
un premier processeur (202) ;
une pluralité de circuits mémoire (204);
un bus de données, DATA, couplant le premier processeur (202) à chacun des circuits mémoire (204), dans lequel chacun des circuits mémoire (204) a un port de données qui a une largeur de m bits et le bus de données a une largeur de n bits, n étant supérieur à m, le port de données de chaque circuit mémoire (204) étant couplé à une tranche correspondante de m bits du bus de données, le premier processeur (202) étant adapté à fournir une ou plusieurs premières adresses pour une valeur de données de n bits à lire ou écrire par l'intermédiaire du bus de données dans la pluralité de circuit mémoire (204), le dispositif informatique étant **caractérisé en ce qu'**au moins un premier des circuits mémoire (204) comprend au moins un autre processeur (206) capable :
- d'accéder à des mots de données du premier circuit mémoire (204), la largeur m du port de donnée du premier circuit mémoire étant inférieur au mot de donnée,
- et de réaliser des opérations sur les mots de données ;
le dispositif informatique étant également caractérisé ce que le premier processeur et/ou un autre circuit (208) est configuré pour lire ou écrire la valeur de données de n bits dans le premier circuit mémoire (204) :
- en convertissant la première adresse en une pluralité de deuxièmes adresses correspondant à des emplacements mémoire de m bits dans le premier circuit mémoire, au moins deux de la pluralité de deuxièmes adresses étant des adresses contiguës ; et
- en réalisant l'opération de lecture ou d'écriture de la valeur de données de n bits dans le premier circuit mémoire sur une pluralité d'opérations d'accès mémoire.

2. Dispositif informatique selon la revendication 1, dans lequel chaque autre processeur (206) est configuré pour effectuer des opérations de traitement des données stockées par le premier circuit mémoire (204) sur la base de commandes fournies par le premier processeur.

3. Dispositif informatique selon la revendication 1 ou 2, dans lequel la largeur n du bus de données est un multiple p de la largeur m du port de données de chaque circuit mémoire, et dans lequel il y a p circuits mémoire.

4. Dispositif informatique selon l'une quelconque des revendications 1 à 3, dans lequel la conversion d'adresse comprend une permutation d'adresses telle qu'un ou plusieurs des bits les plus significatifs (MSB) desdites une ou plusieurs premières adresses deviennent un ou plusieurs bits les moins significatifs (LSB) de la pluralité de deuxièmes adresses désignant le premier circuit mémoire.

5. Dispositif informatique selon l'une quelconque des revendications 1 à 4, dans lequel lesdites une ou plusieurs premières adresses sont des adresses dans un espace d'adressage (HGAS) du premier processeur, et les adresses de la pluralité de deuxièmes adresses sont des adresses dans un espace d'adressage local (DLAS) desdits un ou plusieurs autres processeurs, dans lequel l'espace d'adressage local est linéaire ou linéaire par segments.

6. Dispositif informatique selon l'une quelconque des revendications 1 à 5, comprenant en outre un cache de données (1000), et un circuit de permutation de données (1001, 1116) adapté à réaliser une permutation de ligne de cache sur une ou plusieurs lignes (L0, L1, L2) du cache de données (1000), le cache de données (1000) comportant des lignes de cache mémorisant chacune une pluralité de mots de données, chaque mot de données comprenant une pluralité d'octets de données, et dans lequel la permutation de ligne de cache mémorise les octets formant un premier des mots de données dans des emplacements de mémorisation du cache associés au premier circuit mémoire.

7. Dispositif informatique selon la revendication 6, dans lequel le cache de données (1000) est couplé aux circuits mémoire (204) par l'intermédiaire d'un bus de données, et dans lequel le circuit de permutation de données est un circuit de transposition d'octets (1116) couplé entre le bus de données et le cache de données (1000) et adapté à réaliser la permutation de ligne de cache de chaque valeur de données mémorisée dans ou chargée à partir du cache.

8. Dispositif informatique selon l'une quelconque des revendications 1 à 7, dans lequel le premier processeur et/ou un autre circuit (208) sont adaptés à déterminer si lesdites une ou plusieurs premières adresses tombent dans un segment d'adresses associé à un ou plusieurs des autres processeurs (206), et à réaliser la conversion d'adresse si lesdites une ou plusieurs premières adresses tombent dans le segment d'adresses.

9. Dispositif informatique selon l'une quelconque des revendications 1 à 8, dans lequel une pluralité de bits les moins significatifs de la première adresse est identique à une pluralité de bits les moins significatifs de l'une des deuxièmes adresses.

10. Dispositif informatique selon l'une quelconque des revendications 1 à 9, dans lequel un registre de commande de plus de m bits est mappé vers l'espace d'adressage du premier circuit mémoire, le registre de commande comprenant au moins un bit de commande, dans lequel le premier processeur (202) est adapté à réaliser une opération d'écriture dans le registre de commande sur une pluralité d'opérations d'accès mémoire, un octet du registre de commande comprenant le bit de commande étant écrit par une opération finale des opérations d'accès en mémoire et impliquant une modification du bit de commande.

11. Dispositif informatique selon l'une quelconque des revendications 1 à 10, dans lequel le premier circuit mémoire (204, 800) est une puce de circuit intégré intégrant une matrice mémoire (802) et lesdits un ou plusieurs autres processeurs (DPU 0, DPU 1).

12. Dispositif informatique selon l'une quelconque des revendications 1 à 10, dans lequel le premier circuit mémoire (204, 800) comprend une première puce de circuit intégré comprenant une matrice mémoire et une autre puce de circuit intégré comprenant lesdits un ou plusieurs autres processeurs (DPU 0, DPU 1).

13. Dispositif informatique selon la revendication 11 ou 12, dans lequel le premier circuit mémoire (204, 800) comprend une pluralité d'autres processeurs (DPU 0, DPU 1) chacun étant associé à un espace d'adressage correspondant de la matrice mémoire.

14. Dispositif informatique selon l'une quelconque des revendications 1 à 13, dans lequel le premier processeur (202) comprend un ou plusieurs circuits de code de correction d'erreur (ECC) adaptés à insérer un ou plusieurs bits ECC dans chaque valeur de m bits.

15. Dispositif informatique selon l'une quelconque des revendications 1 à 14, dans lequel le premier processeur (202) comprend un ou plusieurs circuits de code de correction d'erreur (ECC) adaptés à générer des bits ECC à mémoriser dans le premier circuit mémoire (204) pendant une autre opération d'accès mémoire.

16. Procédé comprenant :
réaliser, par un premier processeur (202), une opération de lecture ou d'écriture, à une ou plusieurs premières adresse, d'une valeur de données de n bits dans une pluralité de circuits mémoire par l'intermédiaire d'un bus de données (DATA) couplant le premier processeur (202) à chacun des circuits mémoire, chacun des circuits mémoire comportant un port de données qui a une largeur de m bits et le bus de données a une largeur de n bits, n étant supérieur à m, le port de données de chaque circuit mémoire (204) étant couplé à une tranche correspondante de m bits du bus de données, le procédé étant **caractérisé en ce que** le premier circuits mémoire comprend au moins un autre processeur (206) capable :
- d'accéder à des mots de données du premier circuit mémoire (204), la largeur m du port de donnée du premier circuit mémoire étant inférieur au mot de donnée,
- de réaliser des opérations sur les mots de données ; le procédé étant également **caractérisé en ce que** l'opération de lecture ou d'écriture comprend :
- fournir, par le premier processeur (202), la première adresse;
- convertir la première adresse en une pluralité de deuxièmes adresses correspondant à des emplacements mémoire de m bits dans le premier circuit mémoire, au moins deux de la pluralité de deuxièmes adresses étant des adresses contiguës ; et
- réaliser l'opération de lecture ou d'écriture de la valeur de données de n bits dans le premier circuit mémoire sur une pluralité d'opérations d'accès mémoire.

17. Procédé selon la revendication 16, comprenant en outre la réalisation par le premier processeur, d'une permutation de ligne de cache sur une ou plusieurs lignes (L0, L1, L2) d'un cache de données (1000), le cache de données (1000) comportant des lignes de cache mémorisant chacune une pluralité de mots de données, chaque mot de données comprenant une pluralité d'octets de données, et dans lequel la permutation de ligne de cache mémorise les octets formant un premier des mots de données dans des emplacements de mémorisation du cache associés au premier circuit mémoire.

18. Support de stockage électronique mémorisant des instructions de programme qui amènent, lorsqu'elles sont exécutées par le premier processeur (202), la mise en oeuvre du procédé de la revendication 16 ou 17.

## Patentansprüche

1. Ein Computergerät, das folgendes umfasst:
einen ersten Prozessor (202);
eine Vielzahl von Speicherschaltungen (204);
einen Datenbus DATA, der den ersten Prozessor (202) an jede der Speicherschaltungen (204) koppelt, in dem jede der Speicherschaltungen (204) einen Datenport mit einer Breite von m Bits und der Datenbus eine Breite von n Bits aufweist, wobei n größer als m ist, wobei der Datenport jeder Speicherschaltung (204) an einen entsprechenden Bereich des Datenbusses mit m Bits gekoppelt ist, wobei der erste Prozessor (202) so gestaltet ist, dass er eine oder mehrere erste Adressen für einen Datenwert von n Bits bereitstellt, die über den Datenbus in der Vielzahl von Speicherschaltungen (204) gelesen oder geschrieben werden sollen, wobei das Computergerät **dadurch gekennzeichnet ist, dass** zumindest eine erste Speicherschaltung (204) zumindest einen anderen Prozessor (206) umfasst, der in der Lage ist:
- auf Datenwörter der ersten Speicherschaltung (204) zuzugreifen, wobei die Breite m des Datenports der ersten Speicherschaltung kleiner als das Datenwort ist,
- Operationen an den Datenwörtern vorzunehmen, wobei das Computergerät auch **dadurch gekennzeichnet ist, dass** der erste Prozessor und/oder eine andere Schaltung (208) so konfiguriert ist/sind, dass der Datenwert von n Bit in der ersten Speicherschaltung (204) gelesen oder geschrieben werden kann:
- durch Umwandeln der ersten Adresse in eine Vielzahl von zweiten Adressen, die den m-Bit-Speicherplätzen in der ersten Speicherschaltung entsprechen, wobei mindestens zwei der Vielzahl von zweiten Adressen aufeinander folgende Adressen sind; und
- durch Ausführen des Vorgangs des Lesens oder Schreibens des Wertes von n-Bit-Daten in der ersten Speicherschaltung bei einer Vielzahl von Speicherzugriffsoperationen.

2. Computergerät nach Anspruch 1, in dem jeder andere Prozessor (206) so konfiguriert ist, dass basierend auf Befehlen, die von dem ersten Prozessor bereitgestellt werden, Verarbeitungsvorgänge an Daten durchgeführt werden können, die von der ersten Speicherschaltung (204) gespeichert sind.

3. Computergerät nach Anspruch 1 oder 2, in dem die Breite n des Datenbusses ein Vielfaches p der Breite m des Datenports jeder Speicherschaltung ist, und in dem es p Speicherschaltungen gibt.

4. Computergerät nach einem der Ansprüche 1 bis 3, in dem die Adressumwandlung eine Adresspermutation umfasst, bei der eines oder mehrere der höchstwertigen Bits (MSB) einer oder mehrerer erster Adressen zu einem oder mehreren der niedrigstwertigen Bits (LSB) der Vielzahl der zweiten Adressen werden, die die erste Speicherschaltung bezeichnen.

5. Computergerät nach einem der Ansprüche 1 bis 4, in dem eine oder mehrere erste Adressen Adressen in einem Adressraum (HGAS) des ersten Prozessors sind, und die Adressen der Vielzahl der zweiten Adressen Adressen in einem lokalen Adressraum (DLAS) des oder der anderen Prozessoren sind, in dem der lokale Adressraum linear oder linear in Segmenten ist.

6. Computergerät nach einem der Ansprüche 1 bis 5, der des Weiteren einen Daten-Cache (1000) und eine Daten-Permutationsschaltung (1001, 1116) umfasst, die so gestaltet ist, dass eine Cache-Zeilen-Permutation auf einer oder mehreren Zeilen (LO, L1, L2) des Daten-Cache (1000) durchgeführt werden kann, wobei der Daten-Cache (1000) Cache-Zeilen aufweist, die jeweils eine Vielzahl von Datenwörtern speichern, wobei jedes Datenwort eine Vielzahl von Datenbytes umfasst, und in dem die Cache-Zeilen-Permutation die Bytes, die ein erstes der Datenwörter bilden, an Cachespeicherplätzen speichert, die der ersten Speicherschaltung zugeordnet sind.

7. Computergerät nach Anspruch 6, in dem der Daten-Cache (1000) über einen Datenbus an die Speicherschaltungen (204) gekoppelt ist, und in dem die Daten-Permutationsschaltung eine Byte-Transpositionsschaltung (1116) ist, die zwischen den Datenbus und den Daten-Cache (1000) gekoppelt und so gestaltet ist, dass eine Cache-Zeilen-Permutation jedes Datenwerts durchgeführt werden kann, der in dem Cache gespeichert ist oder von diesem abgerufen wird.

8. Computergerät nach einem der Ansprüche 1 bis 7, in dem der erste Prozessor und/oder eine andere Schaltung (208) so gestaltet sind, dass bestimmt werden kann, ob eine oder mehrere Adressen in ein Adresssegment fallen, das einem oder mehreren anderen Prozessoren (206) zugeordnet ist, und die Adressenumwandlung durchgeführt werden kann, wenn eine oder mehrere Adressen in das Adresssegment fallen.

9. Computergerät nach einem der Ansprüche 1 bis 8, in dem eine Vielzahl von niederwertigsten Bits der ersten Adresse identisch sind mit einer Vielzahl von niederwertigsten Bits einer der zweiten Adressen.

10. Computergerät nach einem der Ansprüche 1 bis 9, in dem ein Steuerregister mit mehr als m Bits dem Adressraum der ersten Speicherschaltung zugeordnet ist, wobei das Steuerregister mindestens ein Steuerbit umfasst, in dem der erste Prozessor (202) so gestaltet ist, dass er einen Schreibvorgang im Steuerregister bei einer Vielzahl von Speicherzugriffsoperationen durchführen kann, wobei ein Byte des Steuerregisters das Steuerbit umfasst, das durch einen letzten Vorgang der Speicherzugriffsoperationen geschrieben wird und eine Änderung des Steuerbits beinhaltet.

11. Computergerät nach einem der Ansprüche 1 bis 10, wobei die erste Speicherschaltung (204, 800) ein integrierter Schaltungschip ist mit einer Speichermatrix (802) und einem oder mehreren anderen Prozessoren (DPU 0, DPU 1).

12. Computergerät nach einem der Ansprüche 1 bis 10, in dem die erste Speicherschaltung (204, 800) einen ersten integrierten Schaltungschip mit einer Speicheranordnung und einen weiteren integrierten Schaltungschip mit einem oder mehreren der anderen Prozessoren (DPU 0, DPU 1) umfasst.

13. Computergerät nach Anspruch 11 oder 12, in dem die erste Speicherschaltung (204, 800) eine Vielzahl anderer Prozessoren (DPU 0, DPU 1) umfasst, die jeweils einem entsprechenden Adressraum der Speichermatrix zugeordnet sind.

14. Computergerät nach einem der Ansprüche 1 bis 13, wobei der erste Prozessor (202) eine oder mehrere Fehlerkorrekturcode-Schaltungen (ECC) umfasst, die so gestaltet sind, dass sie ein oder mehrere ECC-Bits in jeden m-Bit-Wert einfügen.

15. Computergerät nach einem der Ansprüche 1 bis 14, in dem der erste Prozessor (202) eine oder mehrere Fehlerkorrekturcode-Schaltungen (ECC) umfasst, die geeignet sind, ECC-Bits zu erzeugen, die während einer anderen Speicherzugriffsoperation in der ersten Speicherschaltung (204) gespeichert werden.

16. Verfahren, das folgende Schritte umfasst:
das Durchführen eines Lese- oder Schreibvorgangs eines Datenwerts von n Bits in einer Vielzahl von Speicherschaltungen durch einen ersten Prozessor (202) an einer oder mehreren ersten Adressen über einen Datenbus (DATA), der den ersten Prozessor (202) mit jeder der Speicherschaltungen verbindet, wobei jede der Speicherschaltungen einen Datenport mit einer Breite von m Bits und der Datenbus eine Breite von n Bits aufweist, wobei n größer als m ist, wobei der Datenport jeder Speicherschaltung (204) an eine entsprechende Scheibe von m Bits des Datenbusses gekoppelt ist, wobei das Verfahren **dadurch gekennzeichnet ist, dass** die erste Speicherschaltung zumindest einen weiteren Prozessor (206) umfasst, der in der Lage ist:
- auf Datenwörter der ersten Speicherschaltung (204) zuzugreifen, wobei die Breite m des Datenports der ersten Speicherschaltung kleiner als das Datenwort ist,
- Operationen an den Datenwörtern durchzuführen; wobei das Verfahren auch **dadurch gekennzeichnet ist, dass** der Lese- oder Schreibvorgang folgendes umfasst:
- die Bereitstellung der ersten Adresse durch den ersten Prozessor (202);
- die Umwandlung der ersten Adresse in eine Vielzahl von zweiten Adressen, die den m-Bit-Speicherplätzen in der ersten Speicherschaltung entsprechen, wobei zumindest zwei der Vielzahl von zweiten Adressen aufeinanderfolgende Adressen sind; und
- die Durchführung des Lesens oder Schreibens des n-Bit-Datenwerts in der ersten Speicherschaltung bei einer Vielzahl von Speicherzugriffsoperationen.

17. Verfahren nach Anspruch 16, das des Weiteren die Herstellung einer Cache-Zeilen-Permutation auf einer oder mehreren Zeilen (L0, L1, L2) eines Daten-Cache (1000) durch den ersten Prozessor umfasst, wobei der Daten-Cache (1000) Cache-Zeilen aufweist, die jeweils eine Vielzahl von Datenwörtern speichern, wobei jedes Datenwort eine Vielzahl von Datenbytes umfasst, und in dem die Cache-Zeilen-Permutation die Bytes speichert, die an den Cache-Speicherplätzen des Cache, der der ersten Speicherschaltung zugeordnet sind, ein erstes der Datenwörter bilden.

18. Elektronisches Speichermedium zum Speichern von Programmanweisungen, die bei Ausführung durch den ersten Prozessor (202) zur Durchführung des Verfahrens nach Anspruch 16 oder 17 führen.

## Claims

1. A computer device comprising:
a first processor (202);
a plurality of memory circuits (204):
a data bus (DATA),
coupling the first processor (202)
to each of the memory circuits (204), wherein each of the memory circuits (204) has a data port with a width of m bits and the data bus has a length of n bits, n being greater than m, the data port of each memory circuit (204) being coupled to a corresponding set of m bits of the data bus, the first processor (202) being adapted to provide one or several addresses for a data value of n bits to be read or written via the data bus into the plurality of memory circuits (204), the computer device being **characterised in that** at least a first of the memory circuits (204) comprises at least one other processor (206) capable of:
- accessing data words of the first memory circuit (204), the width m of the data port of the first memory circuit being less than the data word,
- and performing operations on the data words;
the computer device also being **characterised in that** the first processor and/or another circuit (208) is configured to read or write the n-bit data value in the first memory circuit (204);
- by converting the first address into a plurality of second addresses corresponding to m-bit memory locations in the first memory circuit, at least two of the second addresses of the plurality of second addresses being contiguous addresses; and
- by performing the reading or writing operation of the n-bit data value in the first memory circuit over a plurality of memory access operations.

2. Computer device according to claim 1, wherein each other processor (206) is configured to perform processing operations on the data stored in the first memory circuit (204) based on control data provided by the first processor.

3. Computer device according to claim 1 or 2, wherein the width n of the data bus is a multiple p of the width m of the data port of each memory circuit, and wherein there are p memory circuits.

4. Computer device according to any of claims 1 to 3, wherein the conversion of addresses comprises an address permutation such as one or more of the most significant bits (MSB) of said one or more first addresses become one or more least significant bits (LSB) of the plurality of second addresses identifying the first memory circuit.

5. Computer device according to any of claims 1 to 4, wherein said one or more first addresses are addresses within an address space (HGAS) of the first processor, and the addresses of the plurality of second addresses are addresses within a local address space (DLAS) of said one or several other processors, wherein the local address space is linear or segmented linear.

6. Computer device according to any of claims 1 to 5, further comprising a data cache (1000), and a data permutation circuit (1001, 1116) adapted to perform a cache line permutation on one or several lines (L0, L1, L2) of the data cache (1000), the data cache (1000) comprising cache lines each memorizing a plurality of data words, each data word comprising a plurality of data bytes, and wherein the cache line permutation memorizes the bytes forming a first of the data words in the cache memory locations associated to the first memory circuit.

7. Computer device according to claim 6, wherein the data cache (1000) is coupled to the memory circuits (204) via a data bus, and wherein the data permutation circuit is a byte transposition circuit (1116) coupled between the data bus and the data cache (1000) and adapted to perform the cache line permutation of each data value memorized in or transferred from the cache.

8. Computer device according to any of claims 1 to 7, wherein the first processor and/or another circuit (208) are adapted to determine whether the said one or more first addresses fall within an address segment associated with one or more of the other processors (206), and to perform the address conversion if said one or more first addresses fall within the address segment.

9. Computer device according to any of claims 1 to 8, wherein a plurality of the least significant bits of the first address is identical to a plurality of least significant bits of one of the second addresses.

10. Computer device according to any of claims 1 to 9, wherein a control register of more than m bits is mapped to the address space of the first memory circuit, the control register comprising at least one control bit, wherein the first processor (202) is adapted to perform a read operation in the control register over a plurality of memory access operations, a byte of the control register comprising the control bit being written by a final operation of the memory access operations and involving a change of the control bit.

11. Computer device according to any of claims 1 to 10, wherein the first memory circuit (204, 800) is an integrated circuit chip comprising a memory matrix (802) and the said one or more other processors (DPU 0, DPU 1).

12. Computer device according to any of claims 1 to 10, wherein the first memory circuit (204, 800) comprises a first integrated circuit chip comprising a memory matrix and another integrated circuit chip comprising the said one or more other processors (DPU 0, DPU 1).

13. Computer device according to claim 11 or 12, wherein the first memory circuit (204, 800) comprises a plurality of other processors (DPU 0, DPU 1), each being associated to an address space corresponding to the memory matrix.

14. Computer device according to any of claims 1 to 13, wherein the first processor (202) comprises one or more error correction code (ECC) circuits adapted to insert one or several ECC bits in each m-bit value.

15. Computer device according to any of claims 1 to 14, wherein the first processor (202) comprises one or more error correction code (ECC) circuits adapted to generate ECC bits to be memorized in the first memory circuit (204) during another memory access operation.

16. Process comprising:
the performance, by a first processor (202), of a reading or writing operation, at one or several first addresses, of a n-bit data value in a plurality of memory circuits via a data bus (DATA) coupling the first processor (202) to each of the memory circuits, each of the memory circuits comprising a data port having a width of m bits and the data bus having a width of n bits, n being greater than m, the data port of each memory circuit (204) being coupled to a corresponding set of m bits of the data bus, the process being **characterized in that** the first memory circuit comprises at least one other processor (206) capable of:
- accessing data words of the first memory circuit (204), the width m of the data port of the first memory circuit being less than the data word,
- performing operations on the data words;
the process being further **characterized in that** the reading or writing operation comprises:
- the provision, by the first processor (202), of the first address;
- the conversion of the first address into a plurality of second addresses corresponding to m-bit memory locations in the first memory circuit, at least two of the plurality of second addresses being contiguous addresses; and
- the performance of the reading or writing operation of the n-bit data value in the first memory circuit over a plurality of memory access operations.

17. Process according to claim 16, further comprising the performance, by the first processor, of a cache line permutation on one or more lines (L0, L1, L2) of a data cache (1000), the data cache (1000) comprising cache lines each memorizing a plurality of data words, each data word comprising a plurality of data bytes, and wherein the cache line permutation memorizes the bytes forming a first one of the data words in the cache memory locations associated to the first memory circuit.

18. Electronic storage medium memorizing program instructions which cause, when they are performed by the first processor (202), the implementation of the process according to claim 16 or 17.
